# FASCICULE DE BREVET EUROPEEN

(11) **EP 2 478 393 B1**
(45) Date de publication et mention de la délivrance du brevet: **14.06.2017**
(21) Numéro de dépôt: 10751963.9
(22) Date de dépôt: 14.09.2010
(51) Int. Cl.: G02B 3/14, G02B 26/08

(54) **DISPOSITIF OPTIQUE A MEMBRANE DEFORMABLE A ACTIONNEMENT PIEZOELECTRIQUE**
OPTISCHE VORRICHTUNG MIT PIEZOELEKTRISCH BETÄTIGTER VERFORMBARER MEMBRAN
OPTICAL DEVICE HAVING A PIEZOELECTRICALLY ACTUATED DEFORMABLE MEMBRANE

(30) Priorité: 15.09.2009 FR 0956327
(43) Date de publication de la demande: 25.07.2012
(73) Titulaire: Webster Capital LLC, Wilmington, Delaware 19801 (US)
(72) Inventeur: BOLIS, Sébastien, 38920 Crolles (FR); MOREAU, Stéphane, 38340 Le Chevalon De Voreppe (FR)
(74) Mandataire: Lang, Johannes
(86) Numéro de dépôt international: PCT/EP2010/063427
(87) Numéro de publication internationale: WO 2011/032925

(56) Documents cités:
- WO-A1-2008/100154
- FR-A1- 2 919 073
- JP-A- 8 114 703
- US-A1- 2002 048 096
- US-B1- 7 369 723

## Description

### DOMAINE TECHNIQUE

La présente invention concerne un dispositif optique à membrane déformable piégeant du fluide et doté de moyens d'actionnement de la membrane de type piézoélectriques pour ajuster le rayon de courbure de la membrane dans sa partie centrale. Un tel dispositif optique à membrane déformable peut être une lentille liquide à focale variable, une lentille liquide à correction d'aberrations optiques, pour de l'optique adaptative, ou un miroir à focale variable.

Les lentilles liquides sont utilisables par exemple dans les téléphones portables avec fonction d'appareil photographique ou de caméra. De nombreux développements sont en cours dont notamment la fonction d'autofocus et la fonction zoom. On cherche lors de l'introduction de ces fonctions, à obtenir un temps de réponse le plus court possible mais aussi à diminuer la consommation d'énergie lors de l'actionnement et à augmenter les variations de la focale à consommation d'énergie donnée, tout en évitant de rendre complexe la fabrication de tels appareils. Plus globalement, on cherche à intégrer le plus possible les constituants des ces appareils photos miniatures pour réduire les coûts, l'encombrement et la consommation d'énergie. Ces appareils photos miniatures, fonctionnant dans le visible, sont connus sous la dénomination anglo-saxonne CCM pour « compact camera module ». La technologie de lentille liquide la plus aboutie pour cette application est pour l'instant celle basée sur le principe de l'électro-mouillage.

Une autre application concerne les caméras fonctionnant dans l'infrarouge (IR). L'avancement en termes d'intégration est moindre, dans la plupart des cas, les optiques sont dissociées des caméras. Plusieurs développements sont en cours dont notamment l'intégration des optiques (création d'un module caméra), l'intégration de la fonction autofocus,... Pour l'instant, les solutions techniques associées ne sont pas connues et demandent à être définies.

Dans une application de miroir à membrane déformable, cette dernière est réfléchissante. On peut être amené à vouloir ajuster la distance focale du miroir et donc son rayon de courbure. Un tel miroir peut être utilisé en ophtalmologie ou en optique adaptative. Enfin, ces dispositifs optiques, qu'ils soient de type lentille ou miroirs peuvent être utilisés pour stabiliser des images.

### ÉTAT DE LA TECHNIQUE ANTÉRIEURE

La demande de brevet FR 2 919 073 décrit un dispositif optique comportant une membrane souple ayant une zone périphérique d'ancrage sur un support, la membrane et le support emprisonnant un volume donné de fluide et des moyens d'actionnement piézoélectrique pour déplacer le liquide au niveau de la zone centrale de la membrane afin de déformer la zone centrale de la membrane. Le volume est sensiblement constant dans une plage de températures donnée. Les moyens d'actionnement sont formés d'une pluralité de micro-poutres radiales, qui sont fixées à une extrémité sur le support et dont l'autre extrémité agit sur la membrane dans une zone située entre la zone centrale et la zone d'ancrage. Un inconvénient de cette configuration est qu'elle est encombrante puisque les moyens d'actionnement prennent appui sur le support. Un autre inconvénient est que pour un encombrement donné, et une consommation énergétique donnée lors de l'actionnement, les performances optiques du dispositif ne sont pas optimales. De manière similaire, pour un encombrement donné, et des performances optiques données, la consommation énergétique est importante lors de l'actionnement.

D'autres demandes de brevet décrivent des dispositifs optiques à moyens d'actionnement piézoélectriques. On peut citer le brevet US 4 802 746 dans lequel un élément cylindrique en matériau piézoélectriques, fermée à ses deux extrémités par des parois en matériau élastique, l'ensemble définissant une cavité contenant un matériau solide élastique.

Dans le brevet américain US 4 407 567, une lentille à distance focale variable comporte une cavité communiquant avec une chambre d'expansion, la cavité étant délimitée par une paroi mobile ancrée sur un support.

Dans la demande de brevet internationale WO 2008/076399 est décrite une lentille à distance focale variable dans lequel des moyens d'actionnement piézoélectriques transmettent une force d'actionnement sensiblement normale à l'axe optique du dispositif, à la membrane via un anneau de poussée qui appuie sur la membrane. Un tel dispositif optique est relativement épais puisqu'il faut empiler les moyens d'actionnement piézoélectriques, l'anneau de poussée, la membrane et la cavité contenant le liquide. Les moyens d'actionnement ne sont pas ancrés sur la membrane.

Dans la demande de brevet internationale WO 2007/017089, il est décrit un dispositif optique à correction d'aberrations optiques. Une membrane souple contribue à emprisonner du liquide. La membrane est dotée, dans une zone intermédiaire située entre une zone d'ancrage et une zone centrale, de moyens d'actionnement piézoélectriques prenant la forme d'un anneau morcelé en plusieurs secteurs. Chacun des morceaux en forme de secteur est destiné à se contracter ou à s'allonger tangentiellement, les forces s'appliquant dans un plan sensiblement normal à l'axe optique du dispositif. Un tel actionnement permet de déformer la membrane localement de manière non symétrique par rapport à l'axe optique. La membrane peut se déformer en faisant des bosses et des creux en périphérie de manière à la faire onduler ce qui permet de corriger les aberrations optiques du dispositif. De tels moyens d'actionnement ne permettent pas de faire varier l'épaisseur de liquide sous la zone centrale de la membrane et donc de faire varier la distance focale du dispositif optique.

La demande de brevet WO2008/100154 montre un dispositif optique comportant une cavité contenant un matériau de type gel ou élastomère fermée par des couvercles transparents. Des moyens d'actionnement de type piézoélectriques coopèrent avec l'un des couvercles qui est en verre. La rigidité de ce couvercle est un frein à l'efficacité de l'actionnement et le matériau contenu dans la cavité, puisqu'il est de type gel ou élastomère, n'apporte pas la contre réaction espérée sous l'effet de l'actionnement pour déformer la zone centrale des couvercles. C'est le centre de la membrane qui déforme le gel ou l'élastomère sous l'effet de l'actionnement et une importante rigidité de cette membrane est requise pour obtenir une déformation donnée. Un tel dispositif optique est peu performant car limité en terme de diamètre optique accessible.

La demande de brevet JP 2002-243918 décrit un dispositif optique à membrane déformable équipée de moyens d'actionnement sur toute sa surface.

La demande de brevet US 2002/0048096 décrit à sa figure 5 un miroir déformable à l'aide d'éléments piézoélectriqes prenant la forme de couronnes concentriques. Aucun fluide de transmission n'est prévu.

### EXPOSÉ DE L'INVENTION

La présente invention a justement pour but de fournir un dispositif optique à membrane déformable telle une lentille ou un miroir qui ne possède pas les inconvénients mentionnés ci-dessus à savoir l'encombrement, la consommation énergétique importante, le manque d'efficacité de l'actionnement.

Un autre but de l'invention est de fournir un dispositif optique à membrane déformable dont la déformée de la membrane peut être ajustée de manière voulue et très finement, que la déformation soit symétrique ou non par rapport à un axe optique du dispositif optique.

Encore un autre but de l'invention est de réaliser un dispositif optique de type lentille qui peut aisément être commandé en passant d'une fonction de stabilisation d'image à une fonction d'autofocus très rapidement et qui peut assumer ces deux fonctions indépendamment l'une de l'autre.

Encore un autre but de l'invention, est de réaliser un dispositif optique de type lentille qui lorsqu'il est monté dans un dispositif de prise de vues permet d'obtenir une fonction zoom grâce à une puissance optique accrue.

Encore un but de l'invention est de fournir un dispositif optique à membrane déformable à compensation active en fonction de la température de manière à conserver une distance focale inchangée même si la température ambiante varie.

Pour y parvenir, la présente invention propose que les moyens d' actionnement soient formés d'un ou plusieurs actionneurs piézoélectriques agencés en couronne, ancrés sur la membrane dans une zone intermédiaire située entre une zone centrale et une zone d'ancrage au support, ces moyens d'actionnement étant sans ancrage avec le support que ce soit via la zone d'ancrage ou directement.

Plus précisément, la présente invention est un dispositif optique à membrane déformable tel que défini dans la revendication 1. La membrane comporte une zone d'ancrage sur un support contribuant à emprisonner une quantité de fluide liquide ou gazeux, une zone centrale apte à se déformer de manière réversible depuis une position de repos, des moyens d'actionnement pour déplacer le fluide sollicitant la membrane dans une zone intermédiaire entre la zone d'ancrage et la zone centrale. Les moyens d'actionnement comportent des moyens d'actionnement principaux piézoélectriques, agencés en au moins une couronne montée autour de la zone centrale, chaque couronne comportant un ou plusieurs actionneurs piézoélectriques, et des moyens d'actionnement supplémentaires piézoélectriques, agencés en au moins une couronne montée autour de la zone centrale, chaque couronne comportant un ou plusieurs actionneurs piézoélectriques, ces moyens d'actionnement principaux piézoélectriques étant ancrés uniquement sur la zone intermédiaire de la membrane, ces moyens d'actionnement supplémentaires piézoélectriques étant ancrés sur la zone intermédiaire et éventuellement sur le support, ces moyens d'actionnement principaux piézoélectriques, ces moyens d'actionnement supplémentaires piézoélectriques et la membrane à laquelle ils sont ancrés formant au moins un bimorphe piézoélectrique, les moyens d'actionnement principaux piézoélectriques et les moyens d'actionnement supplémentaires piézoélectriques se contractant ou s'étendant radialement lors d'un actionnement de manière à engendrer un déplacement dudit fluide depuis la zone intermédiaire vers la zone centrale de la membrane ou vice versa visant à déformer la zone centrale par rapport à sa position de repos.

Les moyens d'actionnement principaux piézoélectriques et les moyens d'actionnement supplémentaires piézoélectriques sont de préférence actionnables de manière indépendante pour assurer des fonctions différentes.

En variante, ils peuvent être actionnés simultanément ou successivement de manière à concourir à réaliser une forte variation de focale pour répondre aux exigences d'une fonction zoom.

Lorsque le dispositif optique compte plusieurs couronnes pour les moyens d'actionnement piézoélectriques principaux et/ou supplémentaires, elles sont montées concentriquement entre elles.

Un actionneur piézoélectrique des moyens d'actionnement piézoélectriques principaux et/ou supplémentaires peut prendre la forme d'une couronne continue.

En variante, les actionneurs piézoélectriques d'une même couronne peuvent prendre la forme de secteurs de couronne ou de barreaux orientés radialement espacés entre eux, la couronne étant morcelée ou continue.

Plusieurs actionneurs piézoélectriques d'une même couronne ou de couronnes voisines peuvent partager un même bloc de matériau piézoélectrique afin de faciliter l'intégration technologique et la gestion des contraintes résiduelles.

Les moyens d'actionnement supplémentaires peuvent être ancrés au support de manière directe ou indirecte, ce qui laisse une grande latitude lors de la conception du dispositif optique.

Les moyens d'actionnement peuvent être ancrés sur une face de la membrane en contact avec ledit fluide et/ou sur une face de la membrane sans contact avec ledit fluide et/ou être intégrés dans la membrane.

La membrane peut comporter, au moins localement, une couche de renfort au niveau de la zone intermédiaire de manière à ce que la zone intermédiaire au niveau de cette couche de renfort soit plus rigide que la zone centrale.

La membrane peut comporter au niveau de la zone centrale une couche continue qui occupe la zone intermédiaire et la zone d'ancrage, cela contribue à garantir une bonne étanchéité.

Le dispositif optique peut comporter, en outre, des moyens de compensation d'une variation de la distance focale du dispositif optique en fonction de la température, cela lui permet de fonctionner sans réglage particulier dans une plage de températures par exemple comprise entre -20°C et +60°C.

Les moyens de compensation peuvent être confondus avec le ou les actionneurs piézoélectriques d'une couronne.

En variante, les moyens de compensation peuvent comporter un ou plusieurs éléments bimorphes thermiques agencés en couronne soit ancrés sur la membrane au niveau de la zone d'ancrage en débordant sur la zone intermédiaire, soit fixés au support à l'opposé de la membrane par rapport audit fluide.

Lorsque les moyens d'actionnement comportent plusieurs actionneurs piézoélectriques, ils sont actionnables séparément les uns des autres ou bien tous ensemble simultanément ou bien encore ils sont actionnables simultanément par groupes. Cela donne donc une grande souplesse pour obtenir une déformation voulue de la membrane dans la zone centrale.

Selon une configuration avantageuse, les moyens d'actionnement peuvent comprendre un ou plusieurs actionneurs piézoélectriques agencés en couronne avec une périphérie intérieure et une périphérie extérieure, la couronne se prolongeant sur de ses périphéries par des actionneurs piézoélectriques en barreaux orientés radialement.

Le dispositif optique peut comporter un ou plusieurs actionneurs piézoélectriques agencés en une couronne, ancrés à la membrane dans la zone intermédiaire et éventuellement dans la zone d'ancrage, aptes à fonctionner passivement par effet piézoélectrique direct et dédiés à une surveillance d'une déformation de la membrane.

Le dispositif optique peut comporter, en outre, un capot de protection fixé sur le support. Le capot peut être muni d'une ouverture au niveau de la zone centrale ou être étanche et emprisonner un autre fluide.

La membrane peut être réalisée à base de matériaux organiques choisis parmi le polydiméthylsiloxane, le polyméthacrylate de méthyle, le polyéthylène téréphtalate, le polycarbonate, le parylène, les résines époxydes, les polymères photosensibles, les silicones, ((à base de matériaux minéraux choisis parmi le silicium, l'oxyde de silicium, le nitrure de silicium, le carbure de silicium, le silicium polycristallin, le nitrure de titane, le carbone diamant, l'oxyde d'étain et d'indium, l'aluminium, le cuivre, le nickel.

Chacun des fluides peut être un liquide choisi parmi le carbonate de propylène, l'eau, un liquide d'indice, une huile optique ou encore un liquide ionique, ou un gaz choisi parmi l'air, l'azote, l'hélium.

Les moyens d'actionnement peuvent être réalisés à base de PZT, de nitrure d'aluminium, de polyfluorure de vinylidène ou de ses copolymères de trifluoroéthylène, de trifluoroéthylène, d'oxyde de zinc, de titanate de barium, de niobate de plomb, de sillénites tels que le titanate de bismuth.

Le dispositif optique peut être une lentille ou un miroir.

La présente invention concerne également un dispositif de prise de vue qui comporte au moins un dispositif optique ainsi caractérisé.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
les figures 1A, 1B montrent, en vue de dessus et en coupe, des moyens d'actionnement principaux d'un premier exemple d'un dispositif optique utile pour la compréhension de l'invention;
les figures 2A à 2E montrent, en vue de dessus, différents exemples des moyens d'actionnement principaux d'un dispositif optique à titre comparatif, ces moyens d'actionnement étant répartis sur une unique couronne ;
les figures 3A à 3D montrent, en vue de dessus, différents exemples des moyens d'actionnement principaux d'un dispositif optique selon l'invention, ces moyens d'actionnement étant répartis sur deux couronnes concentriques, ces figures montrent également un dispositif optique selon l'invention avec des moyens d'actionnement principaux et des moyens d'actionnement supplémentaires, ces derniers n'étant pas ancrés au support ;
les figures 4A, 4B montrent, en coupe, la déformée de la membrane avec respectivement deux points d'inflexion et quatre points d'inflexion ;
les figures 5A à 5D montrent, en vue de dessus, différents exemples de dispositifs optiques selon l'invention dont les moyens d'actionnement comprennent des moyens d'actionnement principaux et supplémentaires, ces derniers étant ancrés au support ;
les figures 6A à 6D montrent, dans des dispositifs optiques selon l'invention, des actionneurs piézoélectriques qui partagent un même bloc de matériau piézoélectrique, que ces actionneurs soient disposés sur une même couronne ou sur des couronnes distinctes, la figure 6E montre que le dispositif optique est doté d'un ou plusieurs actionneurs piézoélectriques aptes à fonctionner passivement par effet piézoélectrique direct et dédiés à une surveillance d'une déformation de la membrane ;
les figures 7A à 7C montrent, en coupe, différentes configurations de l'ancrage au support des moyens d'actionnement supplémentaires ;
les figures 8A, 8B, 8C montrent différentes configurations pour la membrane d'un dispositif optique selon l'invention, les moyens d'actionnement étant omis ;
les figures 9A à 9H montrent dans un dispositif optique différentes configurations pour les moyens d'actionnement et pour la membrane qui est multicouche, les moyens d'actionnement supplémentaires selon l'invention n'étant représentés que sur les figures 9F à 9H ;
les figures 10A à 10F montrent, en vue de dessus, différents agencements entre les moyens d'actionnement principaux et une couche de renfort, des moyens d'actionnement supplémentaires pouvant être vus sur les figures 10C, 10E ;
les figures 11A, 11B montrent la position des moyens d'actionnement pour obtenir des points d'inflexion donnés sur la membrane ;
les figures 12A à 12E montrent différentes configurations du support sur lequel est ancrée la membrane d'un dispositif optique selon l'invention, seuls des moyens d'actionnement principaux étant visibles ;
les figures 13A, 13B montrent un dispositif optique selon l'invention équipé de moyens de compensation d'une variation de sa distance focale due à une variation de température, les moyens d'actionnement supplémentaires n'étant pas représentés pour ne pas surcharger les figures ;
les figures 14A à 14G montrent différentes étapes de fabrication d'un dispositif optique utile pour la compréhension de l'invention ;
les figures 15A, 15B montrent un dispositif optique selon l'invention monté dans un dispositif de prise de vue.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

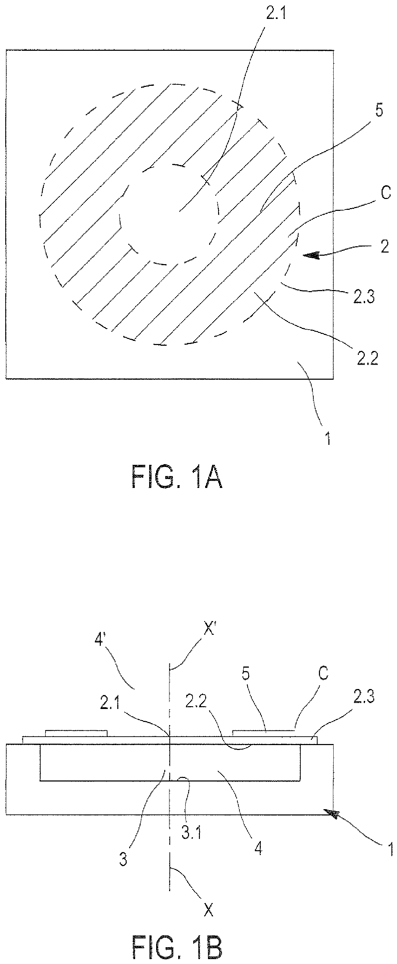

On a représenté sur les figures 1A, 1B un premier mode de réalisation d'un dispositif optique utile pour la compréhension de l'invention. Ce dispositif optique est construit autour d'un axe dit axe optique XX'. Il comporte une membrane 2 dont la périphérie est ancrée de manière étanche sur un support 1 qui dans cet exemple est en forme de cuvette. La membrane 2 comporte donc une zone d'ancrage référencée 2.3. La membrane 2 comporte également une zone centrale 2.1 qui correspond à un champ optique du dispositif optique. Elle est matérialisée par des pointillés. La cuvette est destinée à accueillir un fluide 4 dit premier fluide, ce premier fluide étant liquide ou gazeux. Plus généralement la membrane 2 et le support 1 contribuent à former une cavité 3 dans laquelle est emprisonné le fluide 4.

Une des faces de la membrane 2 est en contact avec le fluide 4 contenu dans la cavité 3. L'autre face de la membrane 2 est en contact avec un second fluide 4' qui peut être l'air ambiant. On verra plus loin une variante dans laquelle le second fluide 4' est piégé, il peut s'agir d'air ou d'un autre gaz ou même d'un liquide.

Par membrane 2, on entend tout film souple faisant office de barrière entre le premier fluide 4 et le second fluide 4' se trouvant de l'autre côté de la barrière par rapport au premier fluide 4.

Dans le cas où le dispositif optique est une lentille, la cavité 3 a un fond 3.1 qui est transparent à un faisceau optique (non représenté) destiné à se propager à travers la lentille. De plus, la membrane 2 est transparente au faisceau optique au moins dans la zone centrale 2.1. Si le dispositif optique est un miroir, la membrane 2 est réfléchissante au moins dans sa zone centrale 2.1.

La membrane 2 est apte à se déformer de manière réversible, depuis une position de repos, sous l'action d'un déplacement du fluide 4 contenu dans la cavité 3 de manière à faire varier l'épaisseur de fluide 4 se trouvant au niveau de la zone centrale 2.1 de la membrane 2 et ainsi courber cette zone de la membrane. Plus la membrane est souple, plus sa déformation sera importante. Le fluide 4 contenu dans la cavité 3 est suffisamment incompressible pour se déplacer, vers la zone centrale 2.1 lorsque l'on applique un effort sur la membrane 2, cet effort étant appliqué sur la membrane 2 dans une zone intermédiaire 2.2 située entre la zone centrale 2.1 et la zone d'ancrage 2.3. Le fluide 4 a un volume sensiblement constant dans une plage de températures donnée. Le fluide 4 contenu dans la cavité sert de « transmission » entre les moyens d'actionnement et la zone centrale de la membrane. Ce fluide 4 peut être un liquide ou un gaz.

On notera que sur la figure 1A le contour de la membrane 2 et le support 1 ont été représentés en carrés alors que la zone centrale 2.1 a été représentée circulaire. Bien entendu, ces formes ne sont pas limitatives. La membrane 2 et le support 1 pourraient être circulaires, rectangulaires, ovoïdes ou autre et la zone centrale 2.1 pourrait être carrée, rectangulaire, ovoïde ou autre.

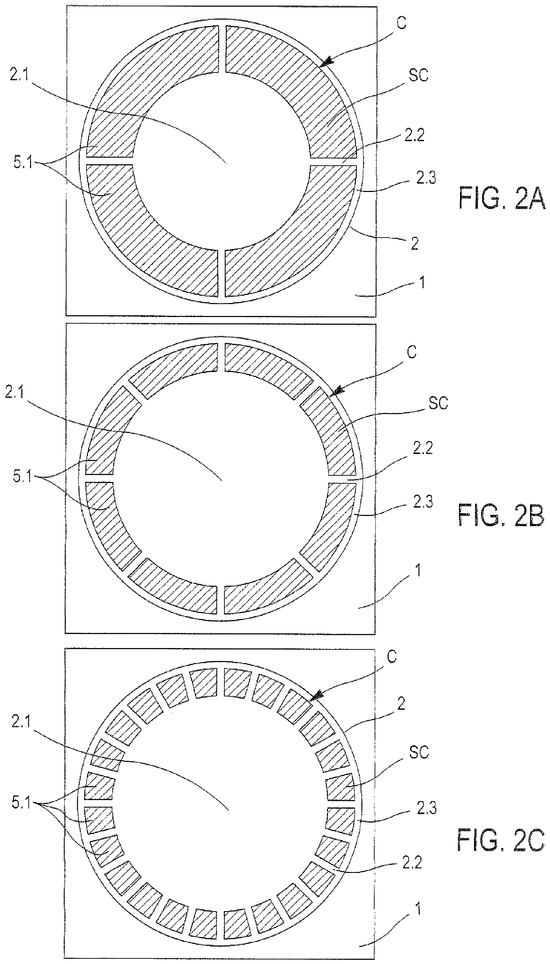

On prévoit des moyens d'actionnement piézoélectrique, pour déplacer le fluide 4 de la cavité 3. Ils comportent des moyens d'actionnement dits principaux 5 qui sollicitent la membrane 2 dans la zone intermédiaire 2.2. Ces moyens d'actionnement 5 sont configurés en au moins une couronne circulaire C montée concentriquement autour de la zone centrale 2.1, chaque couronne C comportant un ou plusieurs actionneurs piézoélectriques 5.1 visibles sur les figures 2A à 2D lorsqu'il y en a plusieurs. Ces moyens d'actionnement piézoélectriques sont ancrés uniquement sur la zone intermédiaire 2.2 de la membrane 2. Chaque couronne C s'étend dans un plan principal lorsque la membrane est plane. Si la membrane est courbe au niveau de l'ancrage les actionneurs piézoélectriques suivent la courbure de la membrane. La zone centrale 2.1 de la membrane peut avoir une courbure qui s'inscrit dans la continuité de celle de la zone centrale lors de l'actionnement. Mais au repos, les courbures de ces deux zones peuvent être différentes.

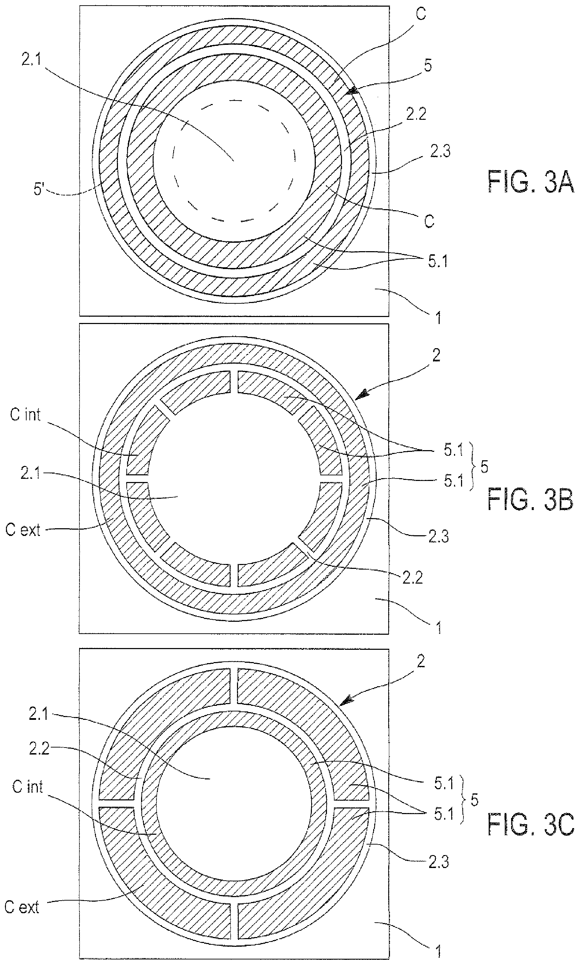

Lorsque les moyens d'actionnement 5 sont configurés selon l'invention en plusieurs couronnes C comme sur la figure 3A par exemple, elles sont montées concentriquement entre elles. On peut considérer que sur cette figure 3A l'une des couronnes peut former les moyens d'actionnement principaux 5 et l'autre couronne C peut former des moyens d'actionnement supplémentaires 5' dont on parlera plus loin. C'est pour cela que l'on a porté avec des pointillés la référence 5'.

Les moyens d'actionnement principaux et plus particulièrement leurs actionneurs piézoélectriques 5.1 appartenant à une même couronne C se déforment radialement lorsqu'ils sont actionnés. Ils se contractent ou s'étendent radialement selon la polarisation qui leur est appliquée, cette déformation ayant pour effet de changer la courbure de la membrane. Cela revient à dire que la différence entre le rayon extérieur et le rayon intérieur de la couronne C varie au moins localement lorsqu'un actionneur piézoélectrique 5.1 est actionné.

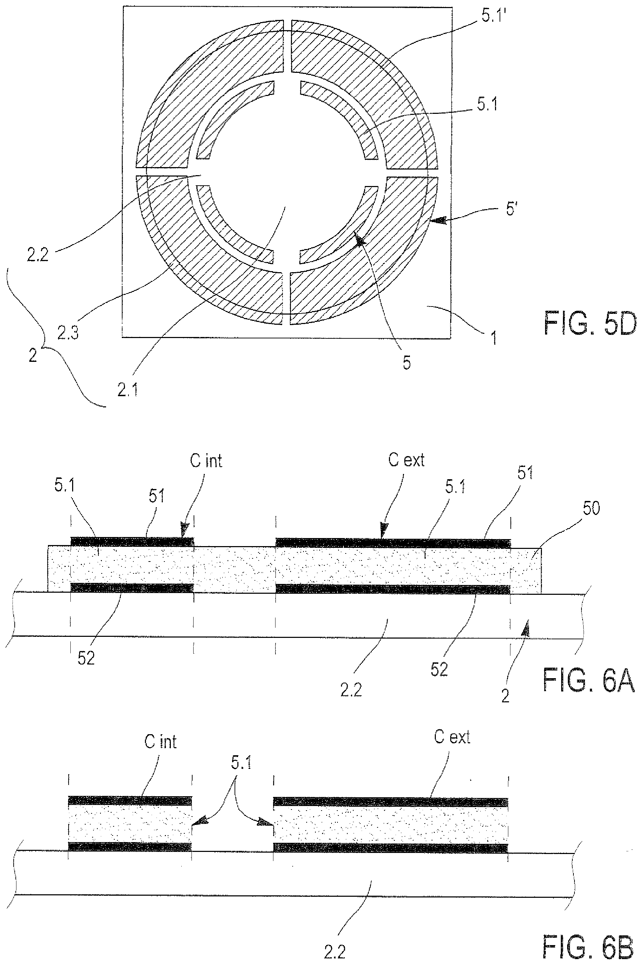

On rappelle qu'un actionneur piézoélectrique comporte un bloc de matériau piézoélectrique pris en sandwich totalement ou partiellement entre deux électrodes destinées, lorsqu'elles sont alimentées, à appliquer un champ électrique au matériau piézoélectrique. Ce champ électrique est utilisé pour commander une déformation mécanique du bloc de matériau piézoélectrique. Le bloc de matériau piézoélectrique peut être monocouche ou multicouche et s'étendre au-delà d'une électrode. Les électrodes situées de part et d'autre d'un bloc de matériau piézoélectrique sont visibles sur les figures 6A, 6B. On a ainsi décrit l'effet piézoélectrique inverse.

Selon l'invention, les moyens d'actionnement 5 principaux sont ancrés uniquement à la zone intermédiaire 2.2 de la membrane 2. Ils sont donc dépourvus d'ancrage au support 1. Ils ne sont pas ancrés non plus à la zone centrale 2.1.

Les moyens d'actionnement supplémentaires 5' sont ancrés dans la zone intermédiaire 2.2 de la membrane mais ils peuvent être ancrés au support 1 ou ne pas être ancrés au support 1.

Ces moyens d'actionnement principaux piézoélectriques 5 et la membrane 2 sur laquelle ils sont ancrés, forment au moins un bimorphe piézoélectrique, ce bimorphe piézoélectrique étant soit hétérogène, soit homogène. On rappelle qu'un bimorphe piézoélectrique comporte une couche de matériau piézoélectrique, équipée d'électrodes, accolée à une couche qui est en matériau piézoélectrique, lorsque le bimorphe est homogène ou en matériau non piézoélectrique lorsque le bimorphe est hétérogène. Dans notre cas, cette couche en matériau piézoélectrique ou non est une couche de la membrane 2.

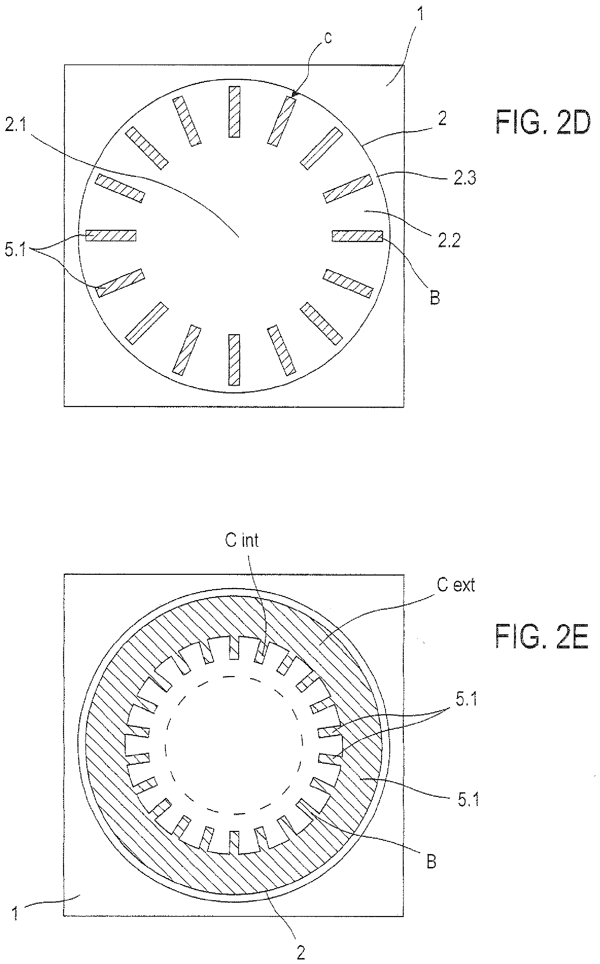

Sur les figures 1A, 1B, on a représenté des moyens d'actionnement principaux 5 comprenant un seul actionneur piézoélectrique 5.1 prenant la forme d'une couronne C continue. Il est bien sûr possible que les moyens d'actionnement principaux 5 comportent plusieurs actionneurs piézoélectriques élémentaires 5.1 agencés en une couronne, la couronne C pouvant alors être discontinue au niveau du matériau piézoélectrique ou au contraire être continue. Chacun des actionneurs piézoélectriques élémentaires 5.1 peut prendre la forme d'un secteur de couronne SC comme sur les figures 2A, 2B, 2C. Sur la figure 2A, il y a quatre actionneurs piézoélectriques élémentaires 5.1, la couronne étant morcelée en quatre secteurs SC, sur la figure 2B, il y a huit secteurs SC et sur la figure 2C il y en a vingt quatre. Au lieu que les actionneurs piézoélectriques élémentaires 5.1 prennent la forme de secteurs de couronne voisins, il est possible qu'ils prennent la forme de barreaux B, agencés radialement, en couronne comme sur la figure 2D. On cherche à ce que l'espace occupé par les actionneurs piézoélectriques élémentaires 5.1, situés sur une même couronne C, soit le plus grand possible sur la zone intermédiaire pour que l'efficacité de l'actionnement soit la plus grande possible. En cherchant à ce que l'espace occupé par les barreaux B soit le plus grand possible et donc à ce que l'espace entre deux barreaux B voisins soit le plus petit possible, on peut être amené à disposer une centaine voire beaucoup plus de barreaux B dans la couronne C.

Sur la figure 2E, on a représenté des moyens d'actionnement principaux 5 agencés en deux couronnes solidaires l'une de l'autre. L'une des couronnes, dans l'exemple la couronne externe Cext, comporte un seul actionneur piézoélectrique, elle est continue. L'autre couronne, dans l'exemple la couronne interne Cint, regroupe une pluralité d'actionneurs piézoélectriques élémentaires agencés en barreaux orientés radialement. Chaque barreau est relié à la couronne externe Cext. On pourrait envisager que la couronne continue soit morcelée et regroupe plusieurs actionneurs piézoélectriques élémentaires. On pourrait également envisager que ce soit la couronne externe qui regroupe la pluralité de barreaux au lieu de la couronne interne. De telles configurations ont pour avantage d'augmenter l'efficacité du dispositif optique. Cela garantit une variation de distance focale significative grâce à la surface piézoélectrique continue tout en permettant d'incliner l'axe optique du dispositif pour assurer par exemple une fonction de stabilisation d'image grâce à la couronne morcelée.

On a déjà mentionné que les moyens d'actionnement principaux 5 pouvaient être répartis sur plusieurs couronnes C montées concentriquement autour de la zone centrale 2.1. Cette variante est illustrée sur la figure 3A. Dans cette configuration, il n'y a qu'un seul actionneur piézoélectrique 5.1 par couronne C. Les deux couronnes C sont, conformément à l'invention, solidaires de la membrane 2 et dépourvues d'ancrage au support 1. Elles n'empiètent pas sur la zone d'ancrage 2.3, ni d'ailleurs sur la zone centrale 2.1. On notera que cette figure 3A peut également représenter les moyens d'actionnement principaux schématisés par l'une des couronnes C et les moyens d'actionnement supplémentaires schématisés par l'autre couronne C. Dans cette configuration, les moyens d'actionnement supplémentaires ne sont ancrés qu'à la membrane 2, dans la zone intermédiaire 2.2.

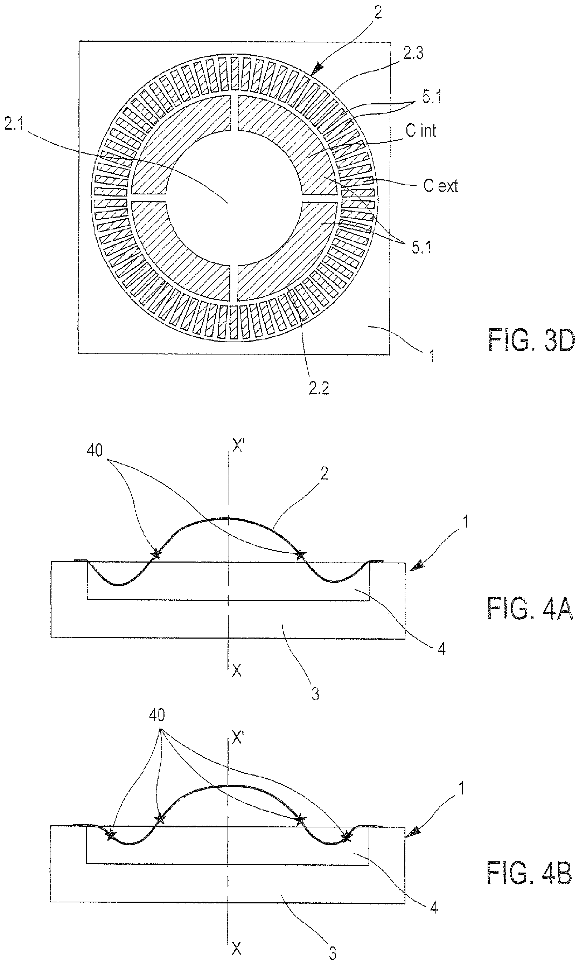

De manière similaire à ce qui a été exposé aux figures 2A à 2D, il est possible que sur une couronne C, on trouve plusieurs actionneurs piézoélectriques élémentaires 5.1 et que sur une autre couronne C ou d'autres couronnes, on en trouve qu'un seul, comme illustré sur les figures 3B et 3C. Sur la figure 3B, la couronne externe Cext correspond à un seul actionneur piézoélectrique 5.1, elle est continue et la couronne interne Cint regroupe plusieurs actionneurs piézoélectriques élémentaires 5.1, il y a plusieurs blocs de matériau piézoélectriques, la couronne étant discontinue. Sur la figure 3C, c'est l'inverse, la couronne externe Cext regroupe plusieurs actionneurs piézoélectriques élémentaires 5.1, il y a plusieurs blocs de matériau piézoélectriques et la couronne interne Cint correspond à un seul actionneur piézoélectrique 5.1, elle est continue. Les couronnes discontinues regroupent des actionneurs piézoélectriques élémentaires 5.1 en forme de secteur de couronne. Sur la figure 3D, les deux couronnes Cint, Cext regroupent plusieurs actionneurs piézoélectriques élémentaires 5.1, elles sont discontinues, les actionneurs piézoélectriques élémentaires 5.1 de l'une des couronnes, référencée Cint, sont en forme de secteur de couronne et les actionneurs piézoélectriques élémentaires 5.1 de l'autre couronne Cext sont en forme de barreaux orientés radialement. Dans tous ces cas, l'actionneur piézoélectrique ou les actionneurs piézoélectriques élémentaires 5.1 d'une couronne Cint, Cext sont ancrés à la membrane 2 et sont dépourvus d'ancrage avec le support 1. Cela signifie que les couronnes s'étendent sur la zone intermédiaire 2.2 mais s'arrêtent avant la zone d'ancrage 2.3 de la membrane 2, elles n'empiètent pas sur elle ni d'ailleurs sur la zone centrale 2.1.

Avec des moyens d'actionnement principaux 5 comportant plusieurs actionneurs piézoélectriques élémentaires 5.1, il est possible d'obtenir une déformée de la membrane 2 dans la zone centrale 2.1 aussi bien axisymétrique que non axisymétrique, par contre avec des moyens d'actionnement principaux 5 comportant un seul actionneur piézoélectrique 5.1 par couronne, la déformée de la membrane 2 ne peut être qu'axisymétrique. Par axisymétrique ou non axisymétrique, on entend symétrique ou non symétrique par rapport à l'axe optique XX' du dispositif optique.

Lorsque l'on dispose plusieurs actionneurs piézoélectriques élémentaires 5.1 sur une même couronne, on peut les actionner séparément les uns des autres ou bien tous ensemble simultanément ou bien encore les regrouper en plusieurs groupes d'actionneurs piézoélectriques voisins ou non et actionner tous les actionneurs piézoélectriques d'un groupe simultanément, chaque groupe étant actionné indépendamment d'un autre groupe.

Le fait d'obtenir une déformée de la membrane 2 dans la zone centrale 2.1 non axisymétrique permet d'obtenir un dioptre avantageux pour assurer une fonction de stabilisation d'image.

Si les moyens d'actionnement principaux 5 comportent un mélange de plusieurs actionneurs piézoélectriques élémentaires agencés en une couronne discontinue et d'un actionneur piézoélectrique agencé en une couronne continue, on augmente la surface d'actionnement tout en conservant la possibilité d'une déformation non axisymétrique. Lors de l'actionnement, l'énergie pour déformer la membrane 2 est également augmentée par rapport au cas où il n'y a qu'une seule couronne. Une telle configuration est avantageuse pour cumuler les fonctions de variation de la distance focale et de stabilisation d'images. Ce qui vient d'être dit dans ce paragraphe s'applique également lorsque les moyens d'actionnement principaux correspondent à l'une des couronnes et les moyens d'actionnement supplémentaires à l'autre couronne.

Sur les figures 4A, 4B, on a représenté en coupe la déformée de la membrane 2 après actionnement des moyens d'actionnement principaux selon deux modes différents. On précise que sur les figures 4A et 4B les moyens d'actionnement ne sont pas représentés.

Sur la figure 4A, la déformée possède deux points d'inflexion 40 et sur la figure 4B, elle en possède quatre, les points d'inflexion 40 sont illustrés par des étoiles. La déformée de la membrane 2 illustrée sur la figure 4A peut être obtenue avec les moyens d'actionnement illustrés sur la figure 1A ou sur la figure 3A.

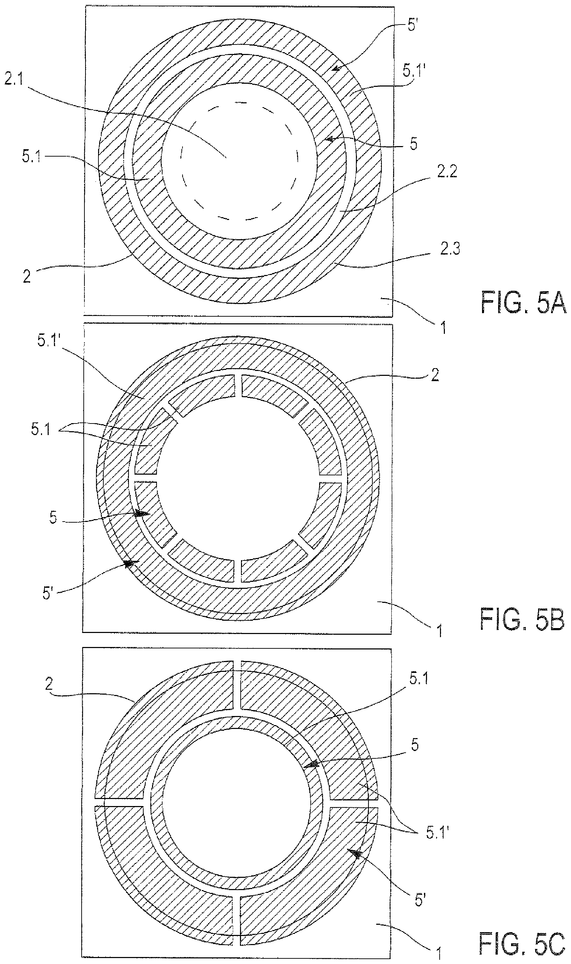

Pour obtenir les quatre points d'inflexion 40, il est possible d'utiliser des moyens d'actionnement principaux 5 tels que décrits précédemment et des moyens d'actionnement supplémentaires 5' comme illustrés sur la figure 5A.

Les moyens d'actionnement principaux 5 sont similaires à ceux représentés à la figure 1A, c'est-à-dire prennent la forme d'un actionneur piézoélectrique 5.1 agencé en couronne continue. Les moyens d'actionnement supplémentaires 5' sont aussi formés d'un actionneur piézoélectrique 5.1' agencé en une couronne continue mais maintenant la couronne est ancrée d'une part sur la membrane 2 et d'autre part sur le support 1, elle s'étend sur la zone intermédiaire 2.2 et empiète sur la zone d'ancrage 2.3 de la membrane 2. Les moyens d'actionnement supplémentaires 5' pourraient posséder plusieurs actionneurs piézoélectriques 5.1' élémentaires agencés en une couronne discontinue comme illustré sur la figure 5C. Le ou les actionneurs piézoélectriques élémentaires 5.1' des moyens d'actionnement supplémentaires forment également avec la membrane 2 chacun un bimorphe piézoélectrique. Les moyens d'actionnement supplémentaires 5' piézoélectriques tout comme les moyens d'actionnement principaux 5 se contractant ou s'étendant radialement lors d'un actionnement de manière à engendrer un déplacement dudit fluide depuis la zone intermédiaire vers la zone centrale de la membrane ou vice versa visant à déformer la zone centrale par rapport à sa position de repos.

Les moyens d'actionnement principaux et les moyens d'actionnement peuvent être commandés de manière indépendante. Le fait de prévoir les moyens d'actionnement principaux et les moyens d'actionnement supplémentaires permet d'ajuster finement la déformation de la membrane dans la zone centrale. L'actionnement des moyens d'actionnement principaux permet par exemple d'assurer une fonction d'autofocus ce qui conduit à une déformation axisymétrique de la zone centrale de la membrane. L'actionnement des moyens d'actionnement supplémentaires peut assurer une fonction de stabilisation d'image, ce qui conduit à une déformation non axisymétrique de la membrane. Les deux actionnements peuvent intervenir indépendamment de manière successive.

L'inverse pourrait bien sûr être envisagé, les moyens d'actionnement principaux peuvent assurer la fonction de stabilisation d'image, les moyens d'actionnement supplémentaires peuvent assurer une fonction d'autofocus. De même dans la perspective de répondre à une application de zoom optique, l'actionnement des moyens d'actionnement principaux permet par exemple d'assurer une fonction d'autofocus, ce qui conduit à une déformée d'amplitude limitée, l'actionnement des moyens d'actionnement supplémentaires peut assurer une fonction de zoom quand les deux moyens d'actionnement sont activés simultanément.

En variante, les moyens d'actionnement principaux 5 peuvent comprendre plusieurs actionneurs piézoélectriques 5.1 élémentaires agencés en une couronne discontinue alors que les moyens d'actionnement supplémentaires 5' comportent un actionneur piézoélectrique 5.1' agencé en une couronne continue comme illustré sur la figure 5B. On peut bien sûr également associer des moyens d'actionnement principaux 5 comprenant plusieurs actionneurs piézoélectriques 5.1 élémentaires agencés en une couronne discontinue et des moyens d'actionnement supplémentaires 5' comprenant plusieurs actionneurs piézoélectriques 5.1' élémentaires agencés en une couronne discontinue comme sur la figure 5D.

On s'arrange pour que les moyens d'actionnement qu'ils soient principaux ou supplémentaires soient décalés par rapport aux points d'inflexion voulus. Lorsque qu'il y a quatre points d'inflexion comme illustré sur la figure 4B, on place avantageusement une couronne entre deux points d'inflexion voisins.

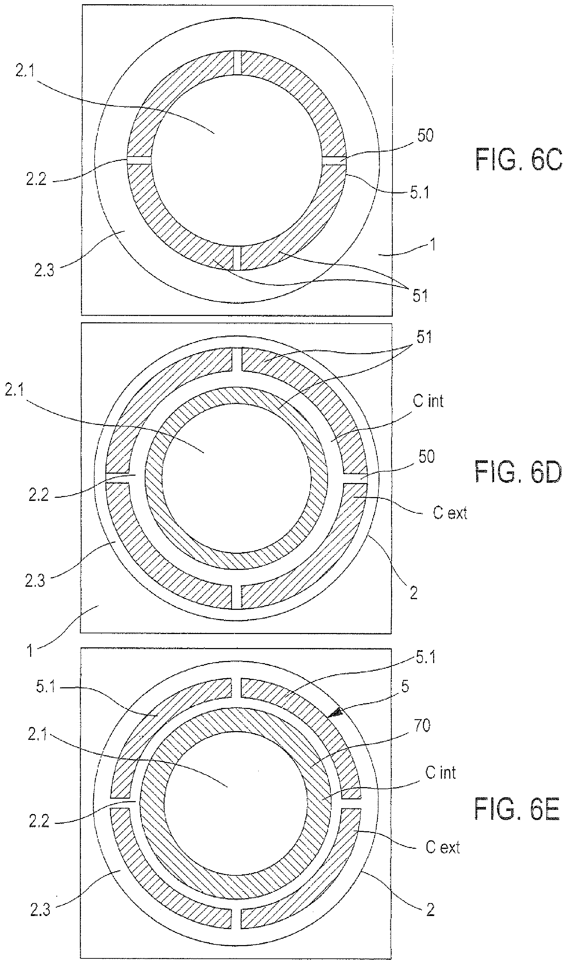

Sur les figures 6A, 6B on a représenté en coupe des moyens d'actionnement 5, comportant des actionneurs piézoélectriques 5.1 répartis sur deux couronnes Cint, Cext, ces actionneurs piézoélectriques 5.1 partagent un même bloc de matériau piézoélectrique 50. Deux jeux d'électrodes 51, 52 sont dessinés pour créer chacun un champ électrique dans le matériau piézoélectrique 50 et engendrer une déformation mécanique. Les deux jeux d'électrodes (51, 52) sont agencés en couronne et placés concentriquement. De tels moyens d'actionnement 5 sont équivalents à deux séries d'actionneurs piézoélectriques 5.1 montés concentriquement, chacune des séries comportant un ou plusieurs actionneurs piézoélectriques comme illustré sur la figure 6B. Ainsi le bloc de matériau piézoélectrique 50 ne se déforme que localement, au niveau d'un jeu d'électrodes polarisées. A titre comparatif, on aurait pu envisager comme illustré sur la figure 6C que les moyens d'actionnement 5 comportent plusieurs actionneurs piézoélectriques élémentaires 5.1 agencés en une couronne et que ces actionneurs piézoélectriques partagent un même bloc de matériau piézoélectrique 50 en forme de couronne continue. Sur ce bloc de matériau piézoélectrique 50, on a placé quatre jeux d'électrodes disjointes agencées en secteur de couronne. Sur la figure 6C, qui est une vue de dessus, on ne voit qu'une seule électrode 51 de chaque jeu. Sur la figure 6D, on a représenté, en vue de dessus, une configuration des moyens d'actionnement 5 comportant un actionneur piézoélectrique configuré en une couronne interne Cint et plusieurs actionneurs piézoélectriques élémentaires configurés en une même couronne externe Cext, les actionneurs partageant tous un même bloc de matériau piézoélectrique 50. Les électrodes de l'actionneur piézoélectrique de la couronne externe sont en couronne tandis que les électrodes des actionneurs piézoélectriques élémentaires de la couronne externe sont en secteur de couronne. Ici encore, sur les figures 6, une des couronnes Cint ou Cext peut faire office des moyens d'actionnement principaux et l'autre Cest ou Cint peut faire office de moyens d'actionnement supplémentaires.

Le mode de couplage entre le matériau piézoélectrique et les électrodes a été représenté transversal pour sa simplicité de mise en oeuvre. La couche en matériau piézoélectrique est prise en sandwich au moins localement entre une ou plusieurs paires d'électrodes. Mais il est bien entendu qu'un autre mode de couplage peut être retenu, par exemple longitudinal ou de cisaillement.

Chaque paire d'électrodes peut être alimentée de manière indépendante des autres, ce qui signifie que toutes les paires d'électrodes peuvent être soumises à des tensions différentes. Ainsi la déformation de la membrane 2 dans la zone centrale 2.1 peut être non axisymétrique et de très nombreuses possibilités de déformation existent.

On utilise donc l'effet piézoélectrique inverse pour commander la déformation de la zone centrale 2.1 de la membrane 2.

Il est possible d'utiliser l'effet piézoélectrique direct pour surveiller la déformation de la membrane 2. On peut acquérir la tension qui apparait aux bornes d'un actionneur piézoélectrique élémentaire non actionné alors que d'autres actionneurs piézoélectriques élémentaires d'une même couronne sont actionnés. Il est également possible de prévoir un ou plusieurs actionneurs piézoélectriques aptes à fonctionner passivement par effet piézoélectrique direct, agencés en couronne spécialement dédiés à cette surveillance comme illustré sur la figure 6E. La couronne interne Cint est formée d'au moins un actionneur piézoélectrique passif 70 détectant la déformation locale de la membrane par effet direct. Les moyens d'actionnement 5 sont formés de plusieurs actionneurs piézoélectriques élémentaires 5.1 agencés en une couronne externe. Ces actionneurs piézoélectriques 5.1 sont actionnables par effet inverse. Cet actionneur est ancré à la membrane dans la zone intermédiaire et éventuellement dans la zone d'ancrage.

Il est bien sûr possible qu'un même actionneur piézoélectrique soit destiné à déformer la membrane par intermittence et soit destiné à surveiller la déformation de la membrane par intermittence. Il peut ainsi être passif à certains moments et actif à d'autres.

Encore une variante serait d'utiliser au lieu d'un actionneur piézoélectrique une jauge de contrainte d'un autre type pour surveiller la déformation de la membrane.

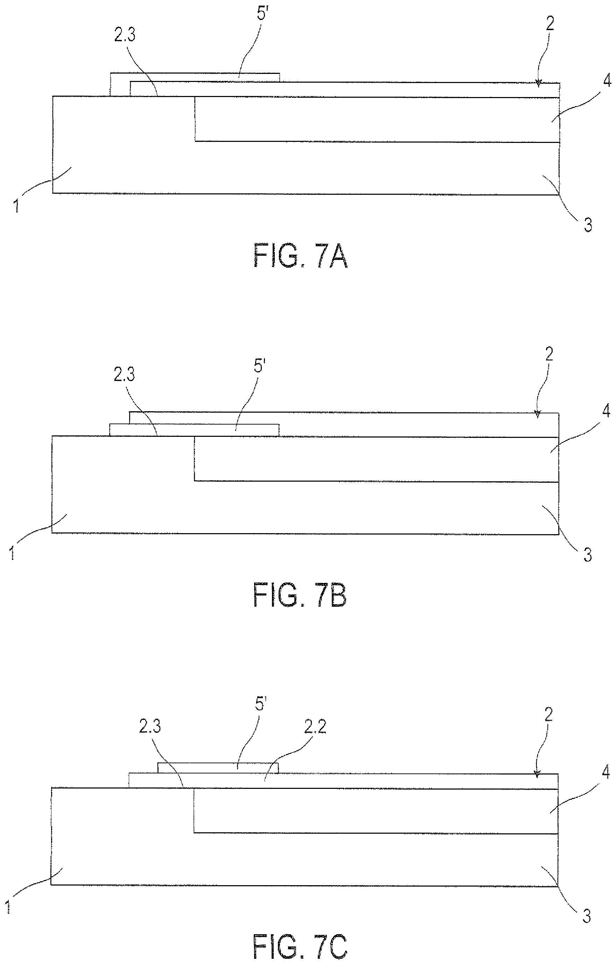

Lorsque le dispositif optique est pourvu de moyens d'actionnement supplémentaires 5' ancrés au support 1, l'ancrage peut être direct comme illustré sur les figures 7A et 7B ou indirect comme illustré sur la figure 7C. Sur la figure 7A, les moyens d'actionnement supplémentaires 5' sont sus-jacents à la membrane 2, ils s'étendent sur la zone intermédiaire 2.2 et la zone d'ancrage 2.3 et se prolongent directement sur le support 1. Ils sont sans contact avec le fluide 4 emprisonné entre la membrane 2 et le support 1. Sur la figure 7B, ils sont sous-jacents à la membrane 2 et de la même manière s'étendent sur la zone intermédiaire 2.2 et la zone d'ancrage 2.3 et se prolongent directement sur le support 1.

Sur la figure 7C, les moyens d'actionnement supplémentaires 5' sont sus-jacents à la membrane 2, ils s'étendent sur la zone intermédiaire 2.2 et sur la zone d'ancrage 2.3, éventuellement de manière partielle, mais n'empiètent pas directement sur le support 1. Sur ces figures 7A, 7B, 7C, les moyens d'actionnement principaux ne sont pas représentés dans un souci de clarté.

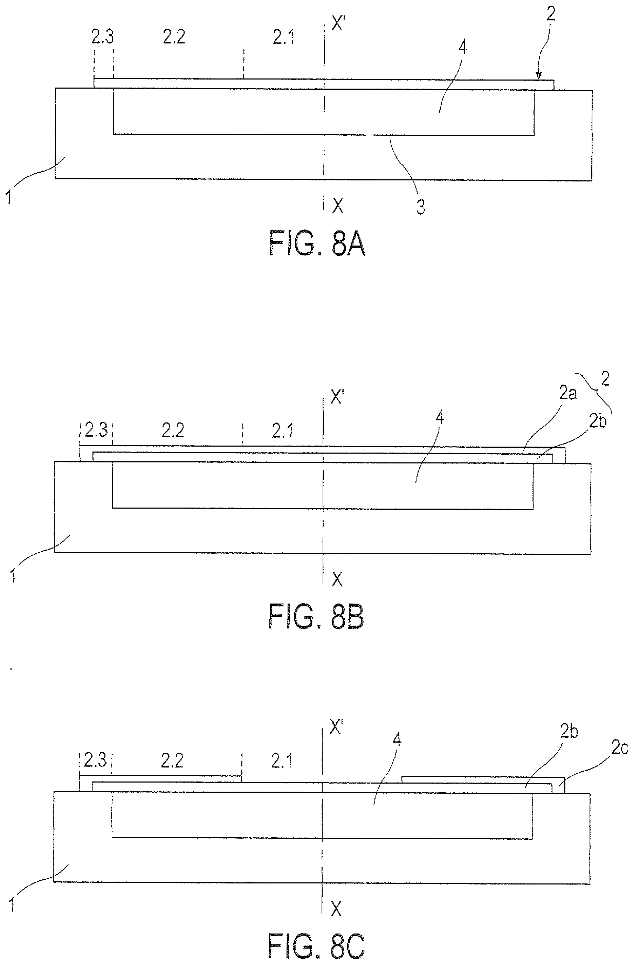

Nous allons maintenant, en se référant aux figures 8A à 8C, donner quelques caractéristiques de la membrane 2. Cette membrane 2 comporte au moins trois zones comme on l'a déjà exposé appelées zone d'ancrage 2.3, zone intermédiaire 2.2 et zone centrale 2.1 en se déplaçant depuis son bord vers son centre. La zone intermédiaire 2.2 est celle qui est directement sollicitée par les moyens d'actionnement, ces derniers ne sont pas représentés. La zone centrale 2.1 dédiée au champ optique est déformée par les mouvements du fluide 4. Cette déformation étant réversible, le matériau de cette zone centrale 2.1 travaillera dans le domaine de la déformation élastique. Sa transparence ou au contraire ses propriétés réflectrices ont déjà été évoquées plus haut. Il est possible que la membrane 2 soit monocouche et homogène depuis la zone centrale 2.1 jusqu'à la zone d'ancrage 2.3 (figure 8A). Elle peut en variante être multicouche comme sur la figure 8B, les deux couches étant référencées 2a, 2b. Elle possède deux couches superposées 2a, 2b dans la zone centrale 2.1, dans la zone intermédiaire 2.2 et dans une partie de la zone d'ancrage 2.3. Dans cette zone d'ancrage 2.3, la couche sus-jacente 2a de l'empilement se prolonge directement sur le support 1 au delà de la couche sous-jacente 2b.

La zone d'ancrage 2.3 de la membrane 2 doit posséder, elle, des propriétés d'adhérence sur le support 1. La couche sus-jacente 2a de la figure 8B peut être choisie pour avoir de meilleures propriétés d'adhérence sur le support 1 que la couche sous-jacente 2b.

La zone intermédiaire 2.2 de la membrane 2 peut avoir des propriétés permettant d'accentuer la déformation induite par les moyens d'actionnement, ce qui signifie qu'on la choisira de préférence avec une rigidité supérieure à celle de la zone centrale 2.1. En fait, il y a une interaction entre les moyens d'actionnement et la membrane 2 proprement dite. La membrane 2 intervient dans l'actionnement, elle forme un bilame avec chaque actionneur piézoélectrique. Il est ainsi possible que la zone intermédiaire 2.2 soit multicouche et plusieurs possibilités existent quant au positionnement des moyens d'actionnement par rapport aux différentes couches de la zone intermédiaire 2.2.

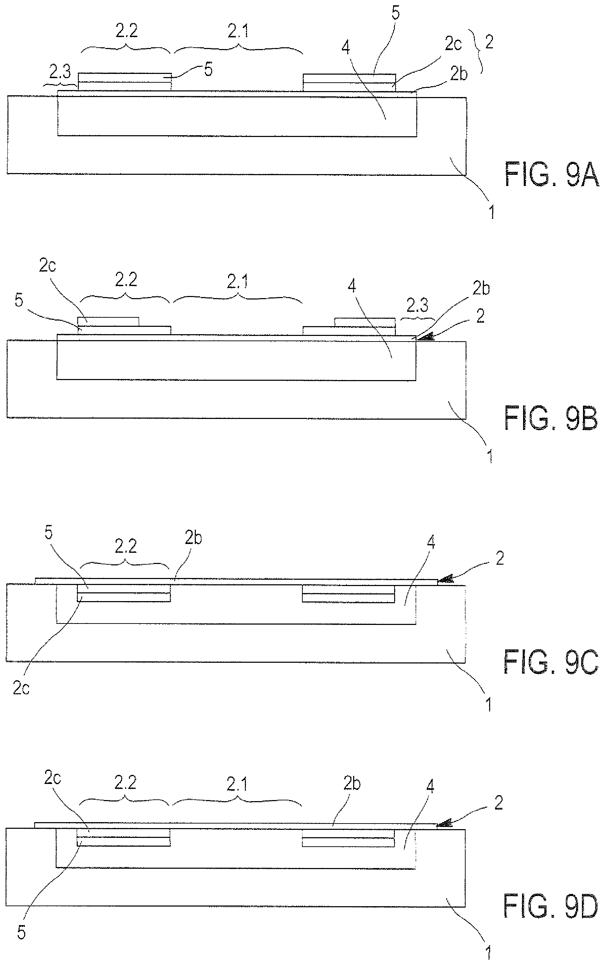

La membrane 2 peut être hétérogène avec au moins une couche dite principale 2b qui occupe la zone centrale 2.1 et dans certaines configurations qui s'étend sur toute la surface de la membrane 2 et au moins une couche de renfort 2c qui ne s'étend que sur une partie de la membrane 2 dont au moins la zone intermédiaire 2.2. Sur la figure 8C qui illustre ce cas, la couche principale 2b s'étend sur toute la surface de la membrane 2 et la couche de renfort 2c s'étend dans cet exemple sur la zone d'ancrage 2.3 et sur la zone intermédiaire 2.2. La couche de renfort 2c empiète directement sur le support 1 de la même manière qu'à la figure 9B avec la couche 2b. Sur les figures 9A, 9B, 9C, la membrane 2 comporte une couche principale continue 2b qui s'étend sur toute sa surface, mais ce n'est pas une obligation comme on le verra ultérieurement.

Les moyens d'actionnement qu'ils soient principaux ou supplémentaires peuvent être sous-jacents à la membrane 2 et être en contact avec le fluide 4 qu'elle contribue à emprisonner avec le support 1 ou être sus-jacents à la membrane 2 ou bien encore être intégrés dans la membrane 2 qui est alors multicouche.

Lorsque les moyens d'actionnement, qu'ils soient principaux ou supplémentaires, sont répartis sur plusieurs couronnes, les actionneurs piézoélectriques agencés sur des couronnes différentes ne sont pas forcément tous placés au même endroit par rapport à la membrane 2. On va passer en revue différentes positions possibles pour les moyens d'actionnement 5, 5' par rapport à la membrane 2 en se référant aux figures 9A à 9H. D'autres possibilités existent encore. Sur les figures 9A à 9E, les moyens d'actionnement représentés sont des moyens d'actionnement principaux 5 comportant un ou plusieurs actionneurs piézoélectriques agencés en une seule couronne, ils ne sont, par conséquent, pas ancrés au support 1. Ils ne sont ancrés qu'à la zone intermédiaire 2.2 de la membrane 2.

Sur la figure 9A, la membrane 2 comporte une couche continue 2b qui s'étend depuis la zone centrale 2.1 jusqu'à la zone d'ancrage 2.3, une couche de renfort 2c sus-jacente qui ne s'étend que dans la zone intermédiaire 2.2. Les moyens d'actionnement 5 sont agencés en une seule couronne, ils sont sus-jacents à la couche de renfort 2c. Ils sont sans contact avec le fluide 4 que la membrane 2 et le support 1 contribuent à emprisonner.

Sur la figure 9B, on retrouve la couche continue 2b qui s'étend de la zone centrale 2.1 à la zone d'ancrage 2.3 et les moyens d'actionnement 5 placés au niveau de la zone intermédiaire 2.2 de la membrane 2 sont pris en sandwich entre la couche continue 2b et la couche de renfort 2c. La couche de renfort 2c et les moyens d'actionnement 5 sont sans contact avec le fluide 4 que la membrane 2 et le support 1 contribuent à emprisonner. La couche de renfort 2c ne coïncide pas totalement avec les moyens d'actionnement 5, ces derniers s'étendent au-delà de la couche de renfort 2c. L'inverse serait possible, la couche de renfort 2c pourrait s'étendre au-delà des moyens d'actionnement 5.

Sur la figure 9C, on retrouve la couche continue 2b et les moyens d'actionnement 5 placés au niveau de la zone intermédiaire 2.2 de la membrane 2 sont pris en sandwich entre la couche continue 2b et la couche de renfort 2c. Mais maintenant la couche de renfort 2c et les moyens d'actionnement 5 sont en contact avec le fluide 4 que la membrane 2 et le support 1 contribuent à emprisonner.

Sur la figure 9D, on retrouve la couche continue 2b et la couche de renfort 2c, placée au niveau de la zone intermédiaire 2.2 de la membrane 2, est en sandwich entre la couche continue 2b et les moyens d'actionnement 5. Mais maintenant la couche de renfort 2c et les moyens d'actionnement 5 sont en contact avec le fluide 4 que la membrane 2 et le support 1 contribuent à emprisonner.

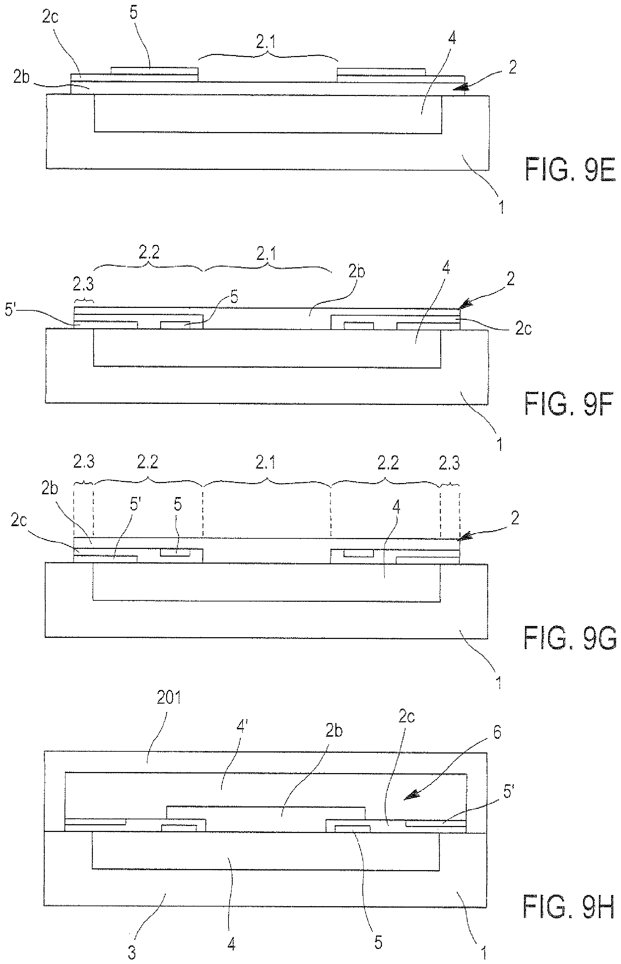

Sur les figures 9A, 9C et 9D, la couche de renfort 2c et les moyens d'actionnement 5 ont des surfaces qui coïncident. Ce n'est bien sûr pas une obligation comme on l'a montré à la figure 9B. Sur la figure 9E, on retrouve une couche continue 2b et une couche de renfort 2c prise en sandwich entre la couche continue 2b et les moyens d'actionnement 5. La couche de renfort 2c s'étend au-delà des moyens d'actionnement 5, elle empiète sur la zone d'ancrage 2.3. Par contre il est préférable qu'elle n'empiète pas sur la zone centrale 2.1 pour ne pas trop la rigidifier.

Sur les figures 9F, 9G, 9H, on a représenté des moyens d'actionnement principaux 5 comportant un ou plusieurs actionneurs piézoélectriques agencés en couronne, sans ancrage avec le support 1 et des moyens d'actionnement supplémentaires 5' comportant un ou plusieurs actionneurs piézoélectriques agencés en couronne ancrée directement sur le support 1.

Sur la figure 9F, les moyens d'actionnement principaux 5 et supplémentaires 5' sont en contact avec le fluide 4 emprisonné entre la membrane 2 et le support 1. Ils sont tous les deux d'un même côté de la couche de renfort 2c qui est sus-jacente à la couche continue 2b. La couche de renfort 2c se trouve entre les moyens d'actionnement 5, 5' et la couche continue 2b. Les moyens d'actionnement principaux 5 et les moyens d'actionnement supplémentaires 5' sont non jointifs, un espace est aménagé entre eux, la couche de renfort 2c occupe cet espace, elle vient en contact avec le fluide 4 dans cet espace. On peut remarquer que la couche continue 2b est sans contact avec les moyens d'actionnement principaux 5, un espace étant aménagé entre eux. La couche de renfort 2c occupe cet espace. Ainsi la couche continue 2b a une épaisseur variable, elle est plus épaisse au niveau de la zone centrale 2.1 qu'au niveau des zones intermédiaire 2.2 et d'ancrage 2.3.

Sur la figure 9G, les moyens d'actionnement supplémentaires 5' et les moyens d'actionnement principaux 5 ne sont pas situés d'un même côté de la couche de renfort 2c. Les moyens d'actionnement supplémentaires 5' sont du côté du fluide 4 que la membrane 2 et le support 1 contribuent à emprisonner. Les moyens d'actionnement principaux 5 sont à l'opposé du fluide 4 par rapport à la couche de renfort 2c. La couche continue 2b s'étend de la zone centrale 2.1 à la zone d'ancrage 2.3 comme dans l'exemple illustré à la figure 9F. Ici encore la couche de renfort 2c occupe l'espace entre les moyens d'actionnement principaux 5 et supplémentaires 5' et l'espace entre les moyens d'actionnement principaux 5 et la couche continue 2b.

La figure 9H est encore un autre exemple de membrane 2, dans lequel les moyens d'actionnement principaux 5 et les moyens d'actionnement supplémentaires 5' ne sont toujours pas d'un même côté de la couche de renfort 2c. Les moyens d'actionnement principaux 5 sont en contact avec le fluide 4 emprisonné entre le support 1 et la membrane 2. Les moyens d'actionnement supplémentaires 5' sont à l'opposé du fluide 4 par rapport à la couche de renfort 2c. Ils sont ancrés au support 1 par l'intermédiaire de la couche de renfort 2c. Une autre différence à signaler par rapport aux configurations précédentes est que la couche 2b présente au niveau de la zone centrale 2.1 n'est pas continue jusqu"à la zone d'ancrage 2.3 comme précédemment. Elle s'étend au niveau de la zone intermédiaire 2.2 mais s'arrête avant la zone d'ancrage 2.3. Ici encore cette couche 2b qui s'étend au niveau de la zone centrale 2.1 est plus épaisse au niveau de la zone centrale 2.1 qu'au niveau de la zone intermédiaire 2.2. L'assemblage entre la couche de renfort 2c et la couche qui occupe la zone centrale 2.1 doit être suffisamment étanche de manière à ce que le fluide 4 que le support 1 et la membrane 2 contribuent à emprisonner ne puisse s'échapper de la cavité, même lorsque les moyens d'actionnement 5, 5' sont actionnés.

Sur les figures 9F à 9H, la couche de renfort 2c est commune aux moyens d'actionnement principaux 5 et supplémentaires 5'. Si l'un de ces moyens d'actionnement comporte des actionneurs piézoélectriques élémentaires agencés en une couronne morcelée en plusieurs secteurs ou barreaux, on peut envisager que la couche de renfort 2c soit elle continue. On verra plus loin qu'en variante, elle peut être discontinue.

On a représenté dans tous ces exemples, la couche 2b qui occupe la zone centrale et la couche de renfort 2c comme monocouche, il est bien entendu que l'une d'entre elles ou les deux peuvent être multicouches.

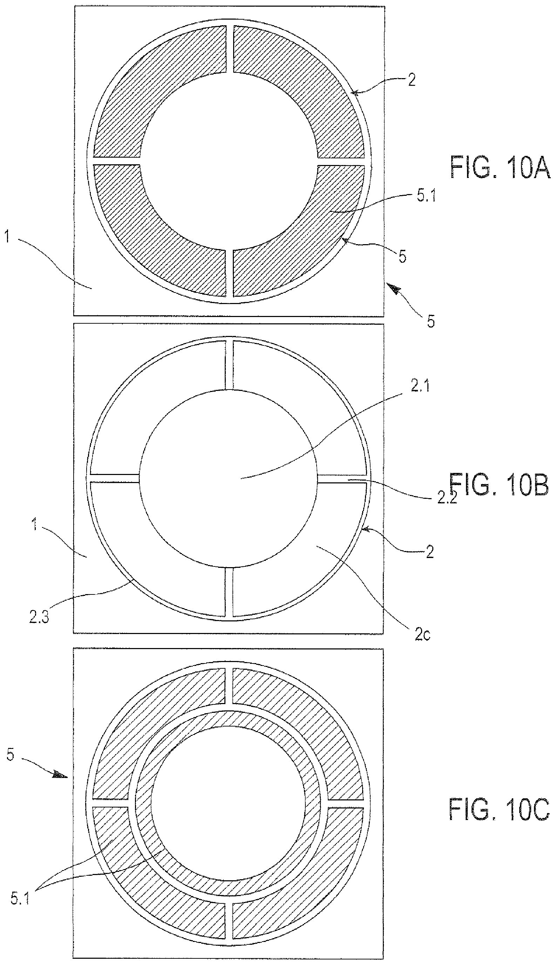

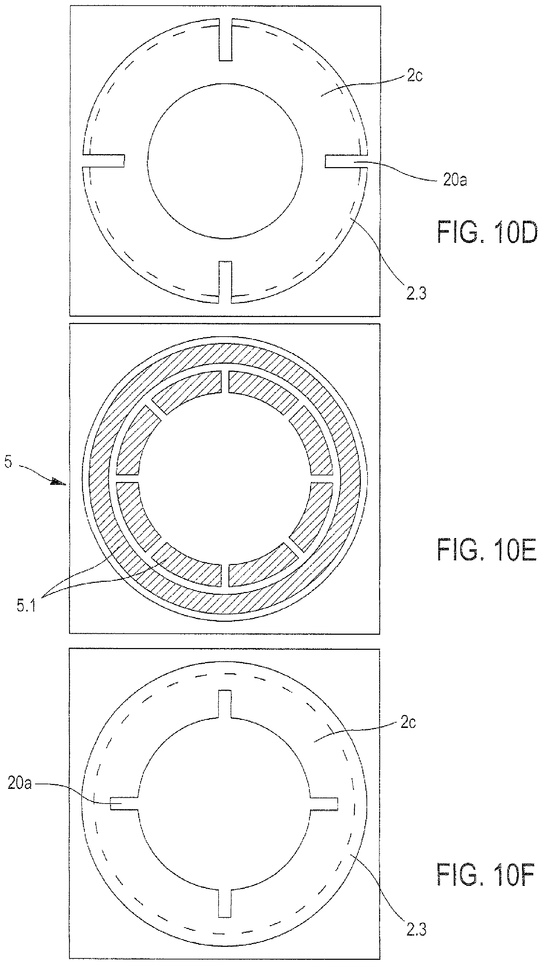

Il est possible que la couche de renfort 2c ne soit pas continue comme illustré sur la figure 10B ou qu'elle soit partiellement discontinue comme illustré sur les figures 10D, 10F. Dans ces configurations le contour de la couche de renfort 2c est sensiblement calqué sur celui des moyens d'actionnement principaux 5.

Sur la figure 10A, on a représenté en vue de dessus les moyens d'actionnement principaux 5 formés de plusieurs actionneurs piézoélectriques 5.1 élémentaires en secteur de couronne agencés en couronne. Sur la figure 10B, on a représenté la couche de renfort 2c, elle est morcelée aussi en quatre secteurs de couronne mais elle est plus grande car elle empiète sur la zone d'ancrage 2.3. Son rayon intérieur est sensiblement égal à celui de la couronne des moyens d'actionnement principaux 5 alors que son rayon extérieur est plus grand que celui des moyens d'actionnement principaux 5. Lors du montage, on superpose les moyens d'actionnement principaux 5 sur la couche de renfort 2c qui se retrouva alors en sandwich entre la couche 2b qui s'étend dans la zone centrale 2.1 et les moyens d'actionnement 5. Les quatre secteurs des moyens d'actionnement 5 sont superposés sur les quatre secteurs de la couche de renfort 2c. Les secteurs des moyens d'actionnement 5 ne débordent pas des secteurs de la couche de renfort 2c. Les moyens d'actionnement supplémentaires ne sont pas représentés dans cette configuration, dans un souci de ne pas trop surcharger les figures (figures 10A, 10B).

Sur la figure 10C, on a représenté les moyens d'actionnement principaux 5 formés d'actionneurs piézoélectriques 5.1 agencés en deux couronnes dont l'une, à l'intérieur, est continue et dont l'autre, à l'extérieur, est discontinue et morcelée en quatre secteurs. La couche de renfort 2c illustrée à la figure 10D prend la forme d'une couronne dont le rayon intérieur est sensiblement égal à celui de la couronne intérieure et dont le rayon extérieur est supérieur à celui de la couronne extérieure des moyens d'actionnement. On suppose, dans cette configuration, que la couche de renfort 2c empiète sur la zone d'ancrage 2.3. La couronne de la couche de renfort 2c est pourvue d'encoches radiales 20a ouvertes depuis le bord extérieur de la couronne, qui sont calées sur l'espace séparant deux secteurs voisins des moyens d'actionnement 5. Ces deux figures 10C et 10D peuvent aussi représenter les moyens d'actionnement principaux formés de l'une des couronnes et les moyens d'actionnement supplémentaires formés de l'autre couronne.

Sur la figures 10E, on a représenté les moyens d'actionnement principaux 5 formés de plusieurs actionneurs piézoélectriques 5.1 agencés en deux couronnes concentriques dont l'une à l'extérieur est continue et dont l'autre intérieure est discontinue et morcelée en huit secteurs. La couche de renfort 2c illustrée à la figure 10F prend la forme d'une couronne dont le rayon intérieur est sensiblement égal à celui de la couronne intérieure et dont le rayon extérieur est sensiblement égal à celui de la couronne extérieure des moyens d'actionnement 5. On suppose dans cette configuration que la couche de renfort 2c n'empiète pas sur la zone d'ancrage 2.3. La couronne de la couche de renfort 2c est pourvue d'encoches radiales 20a ouvertes depuis le bord intérieur de la couronne, elles sont calées sur l'espace séparant deux secteurs voisins des moyens d'actionnement. Ces deux figures 10E et 10F peuvent aussi représenter les moyens d'actionnement principaux formés de l'une des couronnes et les moyens d'actionnement supplémentaires formés de l'autre couronne.

Les différentes configurations représentées ne sont pas limitatives, d'autres sont bien sûr possibles.

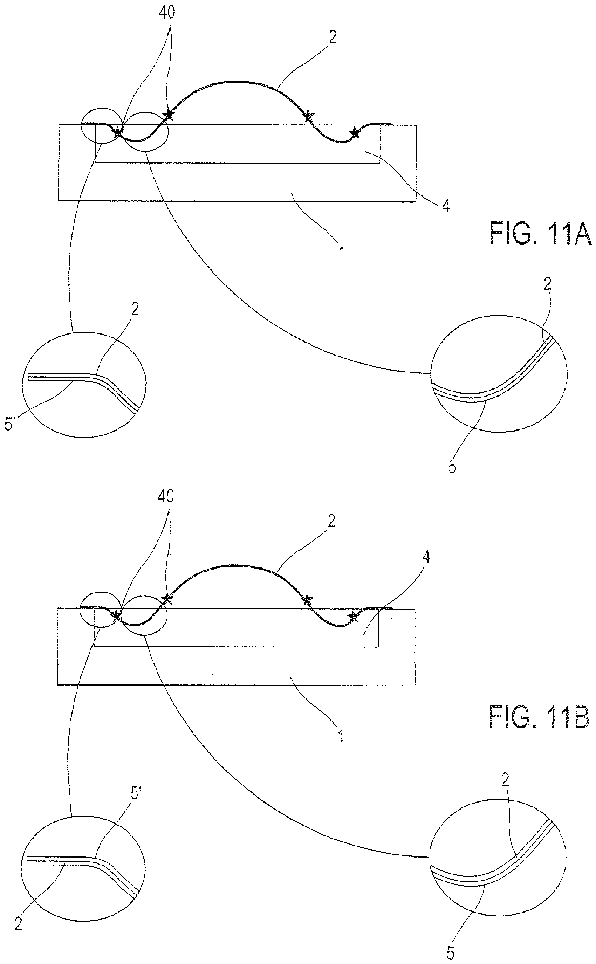

On va maintenant, en se référant aux figures 11A, 11B, expliquer comment obtenir la déformation de la membrane 2. La déformée de la membrane 2 illustrée sur les figures 11A, 11B possède radialement deux points d'inflexion 40 dans la zone intermédiaire 2.2.

Pour obtenir ces deux points d'inflexion 40, on peut utiliser des moyens d'actionnement principaux 5 et des moyens d'actionnement supplémentaires 5' comme illustré à la figure 5A par exemple.

Sur la figure 11A, les moyens d'actionnement principaux 5 et les moyens d'actionnement supplémentaires 5' se trouvent d'un même côté de la membrane 2, dans l'exemple du côté du fluide 4 piégé entre la membrane 2 et le support 1. Lors de l'actionnement, les électrodes associées à ces moyens d'actionnement sont polarisées de manière opposées de manière à procurer des courbures différentes à la membrane 2. Le ou les actionneurs piézoélectriques des moyens d'actionnement principaux 5 subissent un allongement radial et le ou les actionneurs piézoélectriques des moyens d'actionnement supplémentaires 5' subissent une contraction radiale. On peut obtenir le même effet en plaçant les actionneurs piézoélectriques des moyens d'actionnement principaux 5 et des moyens d'actionnement supplémentaires 5' de part et d'autre de la membrane 2 et en polarisant les électrodes de l'actionneur piézoélectrique ou des actionneurs piézoélectriques de l'une des moyens d'actionnement de la même manière que les électrodes de l'actionneur piézoélectrique ou des actionneurs piézoélectriques de l'autre moyen d'actionnement. Les actionneurs piézoélectriques des moyens d'actionnement principaux 5 et des moyens d'actionnement supplémentaires 5' subissent une même déformation soit un allongement radial soit une contraction radiale.

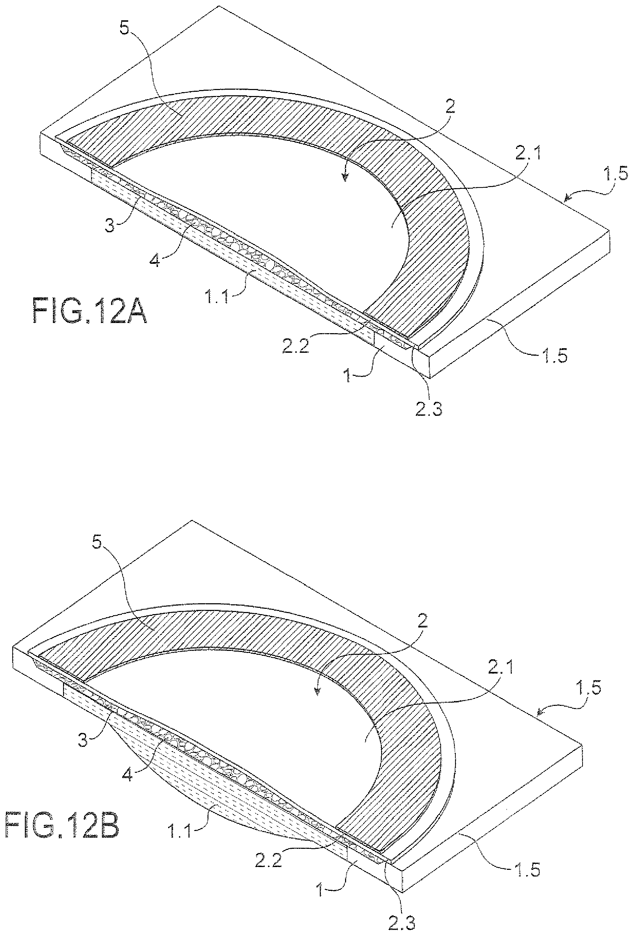

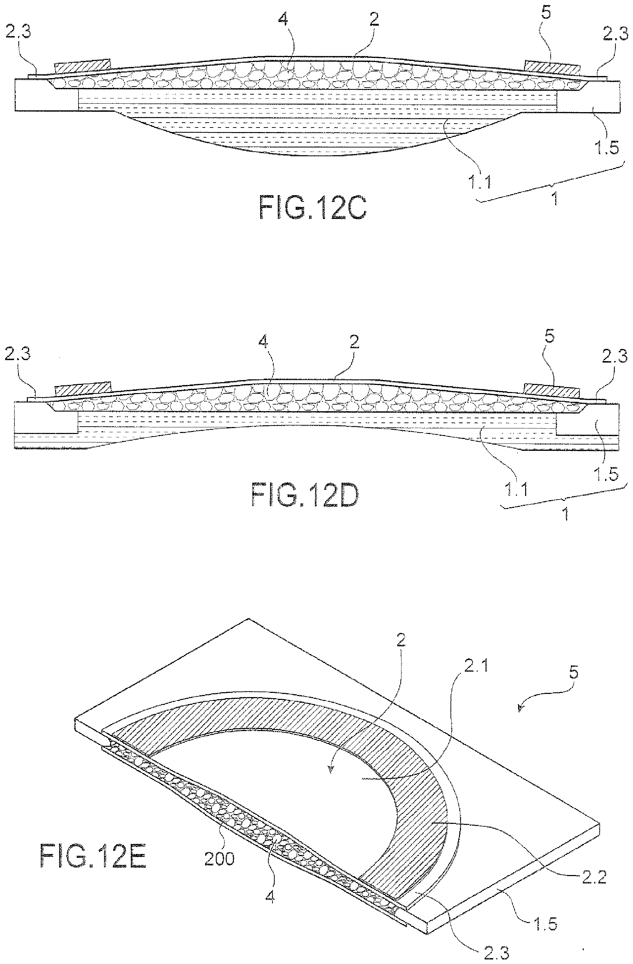

Sur les figures 11A et 11B, la membrane 2 est représentée monocouche, il est bien entendu qu'elle pourrait être multicouche, les moyens d'actionnement décrits à la figure 11A pourraient être transposés dans la configuration de la figure 9F. De manière similaire, les moyens d'actionnement décrits à la figure 11B pourraient être transposés dans les configurations des figures 9G ou 9H. Sur ces figures 12, on a omis de représenter les moyens d'actionnement supplémentaires pour ne pas surcharger les figures. Tout ce qui est décrit au sujet de cette figure concerne bien sûr un dispositif optique objet de l'invention.

Le support 1 peut être monolithique comme on l'a représenté depuis le début de cette description. En variante illustrée sur la figure 12A, il peut être formé par un cadre 1.5 solidaire d'une plaque 1.1 pour former la cuvette 3. La plaque 1.1 matérialise le fond de la cuvette 3, elle est transparente à un rayonnement optique qui va la traverser lorsque le dispositif optique fonctionne en transmission ou est réfléchissante lorsque le dispositif optique fonctionne en réflexion. Il n'y a pas de modification au niveau de la membrane 2, ni au niveau du fluide 4 par rapport à ce qui a été décrit précédemment. Les moyens d'actionnement 5 prennent la forme d'un unique actionneur piézoélectrique agencé en une couronne.

La plaque transparente 1.1 peut être d'épaisseur sensiblement constante, à faces sensiblement parallèles planes, comme sur la figure 12A. Au moins une face pourrait être structurée comme sur les figures 12B, 12C, 12D, où la face extérieure est convexe ou concave. Le choix se fait en fonction des performances optiques recherchées pour le dispositif optique. Elle laisse passer un rayonnement optique qui traversera la lentille. Le cadre 1.5 peut être en matériau semi-conducteur tel que le silicium, ce qui le rend apte à intégrer des circuits associés au traitement de la commande des moyens d'actionnement 5. Les circuits ne sont pas représentés pour ne pas surcharger les figures. La plaque transparente 1.1 peut être en verre ou en matière plastique.

Sur les figures 12B, 12C, la plaque transparente 1.1 est à structure convexe et sur la figure 12D, elle est à structure concave. La structuration de la plaque 1.1 transparente peut être obtenue par usinage ou par moulage par exemple.

Sur la figure 12E, le support 1 est matérialisé par le cadre 1.5 et la plaque transparente 1.1 est remplacée par une seconde membrane 200. La seconde membrane 200 comporte une couche qui a sensiblement la même surface que la première membrane 2. Les deux membranes 2, 200 sont ancrées sur le cadre 1.5, chacune sur une de ses faces principales. Elles contribuent à réaliser un logement pour le liquide 4. Cela permet d'accroître les performances optiques de la membrane 2. Dans l'exemple décrit, les moyens d'actionnement 5 sont prévus sur une seule des membranes 2. L'autre membrane 200 n'est pas actionnée, mais elle se déforme quand même lorsque les moyens d'actionnement 5 sont actionnés. En variante, les deux membranes pourraient être actionnées.

Il est possible que la membrane 2, pourvue des moyens d'actionnement 5, soit coiffée d'un capot de protection 201 qui est scellé au support 1 comme illustré sur la figure 9H. Ce capot 201 délimite une cavité. La fixation peut se faire par exemple par collage moléculaire, par collage organique, par collage anodique, par collage eutectique une couche d'alliage par exemple en Au/Si ou Au/Sn par exemple étant intercalée entre le capot 201 et le support 1 à sceller. Ces techniques de collage sont couramment utilisées dans le domaine de la microélectronique et des microsystèmes.

Le capot 201 délimite une cavité 6 dans laquelle est emprisonné un second fluide 4', la face supérieure de la membrane 2, c'est-à-dire celle qui n'est pas en contact avec le premier fluide 4, est en contact avec le second fluide 4'. Le capot 201, au moins dans sa partie centrale, et le second fluide 4' doivent être transparents pour le rayonnement optique incident qui va soit se réfléchir sur la membrane 2, soit la traverser selon la nature du dispositif optique.

Le capot 201 peut être réalisé en verre ou en matériau organique tel que le polyéthylène téréphtalate PET, le polyéthylène naphtalate, le polymétacrilate de méthyle PMMA, le polycarbonate PC s'il doit transmettre des longueurs d'ondes dans le visible. Le capot 201 assure une protection de la membrane 2 car de tels dispositifs optiques à membrane 2 déformable sont des objets fragiles dont la manipulation est délicate.

Le dispositif optique peut être réalisé par des techniques connues en microélectronique. On peut utiliser des techniques de dépôt en couche mince de type dépôt chimique en phase vapeur, de type dépôt physique par phase vapeur d'électrodéposition, d'épitaxie, d'oxydation thermique, d'évaporation, de laminage de films. Les matériaux organiques ou de type sol gel peuvent être déposés par pulvérisation à la tournette. Des techniques de moulage, d'embossage, de gaufrage à chaud, de nano impression, peuvent être employées pour structurer la face inférieure de substrat comme illustré aux figures 12B à 12D. Des techniques de collage peuvent aussi être utilisées pour le collage de la membrane 2 au support 1 ou d'un fond 3 au cadre 1.5 ou du capot 201 au support 1, ces techniques peuvent par exemple être choisies parmi le collage direct, le collage eutectique, le collage anodique, le collage organique. Des étapes d'amincissement par exemple par rodage, amincissement chimique ou bien combinaison des deux types peuvent être prévues après le collage du fond au cadre. Le dispositif optique peut être fabriqué par lots et tous les capots 201 des différents dispositifs peuvent être réalisés de manière collective.

La membrane 2 peut être réalisée à base de matériaux organiques tels que le polydiméthylsiloxane, le polyméthacrylate de méthyle, le polyéthylène téréphtalate, le polycarbonate, le parylène, les résines époxydes, les polymères photosensibles, les silicones tels que ceux connus sous la dénomination SiNR de chez Shin-Etsu ou sous la dénomination WL5150 de chez Dow Corning ou de matériaux minéraux tels que le silicium, l'oxyde de silicium, le nitrure de silicium, le carbure de silicium, le silicium polycristallin, le nitrure de titane, le carbone diamant, l'oxyde d'étain et d'indium, l'aluminium, le cuivre, le nickel.

Chacun des fluides 4, 4' peut être un liquide comme le carbonate de propylène, l'eau, un liquide d'indice, une huile optique ou encore un liquide ionique, ou un gaz comme l'air, l'azote, l'hélium par exemple.

Le matériau piézoélectrique des moyens d'actionnement 5, 5' peut être choisi parmi le PZT soit Titano-Zirconate de Plomb de formule Pb(Zrₓ,Ti₁₋ₓ)O₃, le nitrure d'aluminium AlN, le polyfluorure de vinylidène (PVDF) et ses copolymères de trifluoroéthylène (TrFE), l'oxyde de zinc ZnO, le titanate de barium BaTiO₃, le niobate de plomb PNbO₃, le titanate de bismuth Bi₄Ti₃O₁₂ ou d'autres sillénites qui sont des oxydes avec un rapport métal/oxygène égal à 2/3.

Le dépôt d'une couche en matériau piézoélectrique tel que du PZT nécessite des recuits à haute température de l'ordre de 800°C. Bien souvent le matériau de la membrane 2 ne supporte pas ces températures. Il faut donc d'abord réaliser les moyens d'actionnement en matériau piézoélectrique et les assembler en suite à la membrane. Lors de la fabrication du dispositif optique selon l'invention, il faut prendre en compte ces contraintes lors de l'élaboration de l'empilement.

Les inventeurs se sont aperçus que puisque les différents matériaux constituants le dispositif optique objet de l'invention n'avaient pas le même coefficient de dilatation thermique, la distance focale du dispositif optique pouvait être amenée à changer de manière non voulue.

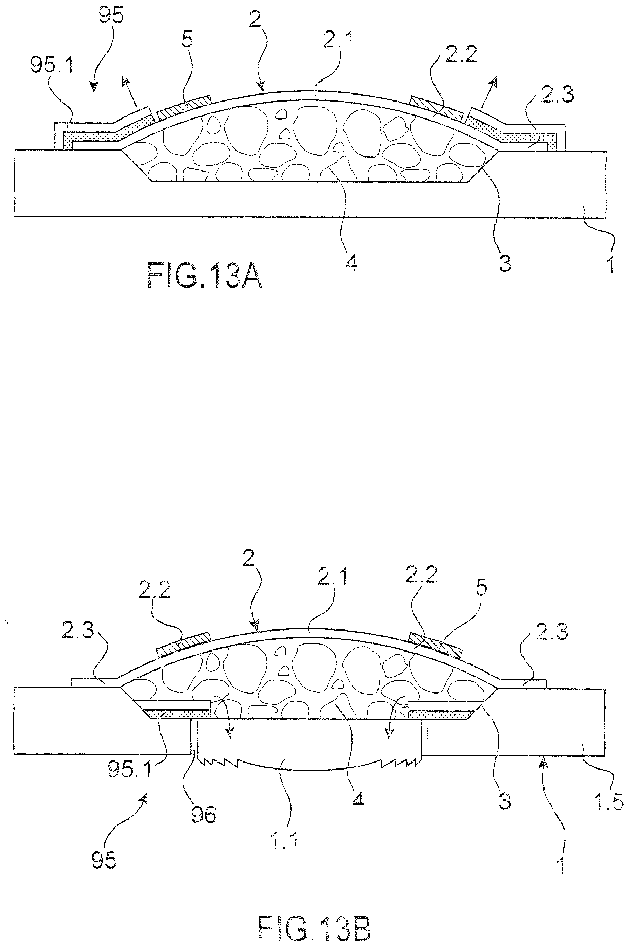

Il est donc possible de prévoir des moyens de compensation d'une variation de la distance focale due à une variation de température. On peut se référer aux figures 13A, 13B.

Ces moyens de compensation 95 sont formées d'un ou plusieurs éléments bimorphes 95.1 thermiques agencés en couronne soit au niveau de la membrane 2 au niveau de la zone d'ancrage 2.3 en débordant sur la zone intermédiaire 2.2 comme sur la figure 13A, soit au niveau du fond 3.1 de la cuvette 3 comme sur la figure 13B. Ces éléments bimorphes 95.1 sont dédiés à cette compensation. Sous l'effet d'une augmentation de la température à l'origine notamment d'une augmentation du volume du fluide 4 emprisonné entre la membrane 2 et le support 1, et donc d'une déformation non voulue de la membrane 2, les éléments bimorphes 95.1 se déforment pour augmenter le volume de la cuvette 3 en augmentant son épaisseur. Un élément bimorphe 95.1 formé de deux couches superposées réalisées dans des matériaux ayant des coefficients de dilatation thermiques différents ne pose pas de problème à un homme du métier.

Dans la configuration de la figure 13B, le support 1 est similaire à celui de la figure 12B. Les éléments bimorphes 95.1 se trouvent, côté fluide 4, sur le cadre 1.5 et débordent sur la plaque transparente 1.1. La plaque transparente 1.1 est concave dans sa partie centrale et comporte des stries à sa périphérie. Un joint de dilatation 96 est inséré entre la plaque 1.1 et le cadre 1.5 pour donner de la souplesse selon l'axe optique et permettre l'augmentation du volume de la cuvette 3. L'augmentation du volume de la cuvette 3 viendra de la déformation de la membrane 2 en bordure de la zone d'ancrage 2.3 et/ou du support 1. L'objectif est qu'une dilatation du fluide 4 emprisonné entre la membrane 2 et le support 1 n'ait pas d'influence sur la flèche de la membrane 2 dans la zone centrale 2.1 et donc sur la distance focale du dispositif optique.

En variante, les moyens de compensation 95 d'une variation de la distance focale sous l'effet d'une variation de température peuvent être réalisés par le ou les actionneurs piézoélectriques 5.1 agencés en au moins une même couronne des moyens d'actionnement principaux 5 ou supplémentaires 5'. Il peut s'agir par exemple de l'actionneur piézoélectrique agencé selon la couronne Cint de la figure 6B.

On réalise alors les blocs en matériaux piézoélectriques des actionneurs piézoélectriques concernés comme des empilements de plusieurs matériaux piézoélectriques ayant des coefficients de dilatation thermiques appropriés de telle sorte que sur la gamme de températures d'utilisation du dispositif optique, par exemple -20°C à +60°C, le ou les blocs de matériau piézoélectrique contrebalancent l'effet de dilatation thermique des autres matériaux du dispositif optique, à savoir : le support 1, éventuellement le capot s'il est présent et le ou les autres blocs de matériau piézoélectrique, le premier fluide 4 et le second fluide 4' ainsi que bien sûr la membrane 2. Cette compensation se fait bien sûr sans soumettre le ou les blocs de matériau piézoélectrique concernés à un champ électrique.

On peut également envisager que les moyens de compensation 95 d'une variation de la distance focale sous l'effet d'une variation de température contribuent à ce que la membrane 2 soit soumise à une contrainte résiduelle sensiblement constante, quelles que soient les conditions climatiques. On évite ainsi que n'apparaisse un flambage ou un fripement de la membrane 2 en cas de contrainte compressive excessive ou au contraire une tension excessive ayant pour effet de dégrader les performances du dispositif optique.

Le choix du ou des matériaux de la membrane 2 est fait pour répondre à des exigences du procédé de fabrication ou pour que la lentille liquide ou le miroir atteigne certaines performances.

Le dispositif optique est d'autant plus performant pour une consommation d'énergie donnée que sa zone centrale 2.1 est souple. Un matériau organique en silicone convient particulièrement bien. Il est préférable alors de rigidifier la membrane au niveau de la zone intermédiaire en prévoyant la couche de renfort, par exemple en matériau minéral tel que l'oxyde de silicium et/ou le nitrure de silicium sur la couche organique qui s'étend de la zone centrale à au moins la zone intermédiaire voire jusqu'à la zone d'ancrage. Une membrane dont la zone centrale 2.1 est en oxyde de silicium ou en nitrure de silicium conviendrait également.

On s'arrange également pour que les moyens d'actionnement une fois fixés sur la membrane 2 ne perturbent pas le comportement attendu de la membrane 2. La déformée de la membrane 2 au repos doit être compatible avec l'usage que l'on veut faire du dispositif optique. La membrane 2 peut, au repos, former un dioptre sensiblement plan, concave ou convexe.

On cherche également à ce qu'au repos, la membrane soit soumise à une contrainte résiduelle en compression suffisamment faible qui n'engendre ni fripement, ni flambage. De la même manière, au repos, la membrane doit être soumise à une contrainte en tension suffisamment faible de manière à ce qu'elle réagisse efficacement à l'actionnement des moyens d'actionnement, ce qui ne serait pas le cas si elle était mise en tension de manière excessive. Un compromis est donc à trouver entre contrainte en tension et en compression.

La couche de renfort doit être suffisamment rigide pour répercuter sur le fluide, emprisonné entre la membrane et le support, la pression appliquée par les moyens d'actionnement et donc générer les déplacements du fluide recherchés. Quelques matériaux utilisables pour la couche de renfort sont listés ci-dessous. Il peut s'agir de matériaux métalliques tels que le titane, le nitrure de titane, l'aluminium dont l'épaisseur sera de l'ordre de quelques dizaines de nanomètres à quelques micromètres et dont le module d'Young est compris entre quelques dizaines de GPa à quelques centaines de GPa. Il peut s'agir de matériaux tels que l'oxyde de silicium, le nitrure de silicium dont l'épaisseur sera de l'ordre de quelques dizaines de nanomètres à quelques micromètres et dont le module d'Young est compris entre quelques dizaines de GPa à quelques centaines de GPa. Enfin il peut s'agir de matériaux organiques tels que les polymères photosensibles et en particulier les benzocyclobutènes (BCB) dont l'épaisseur sera de l'ordre de quelques micromètres et dont le module d'Young est de quelques GPa.

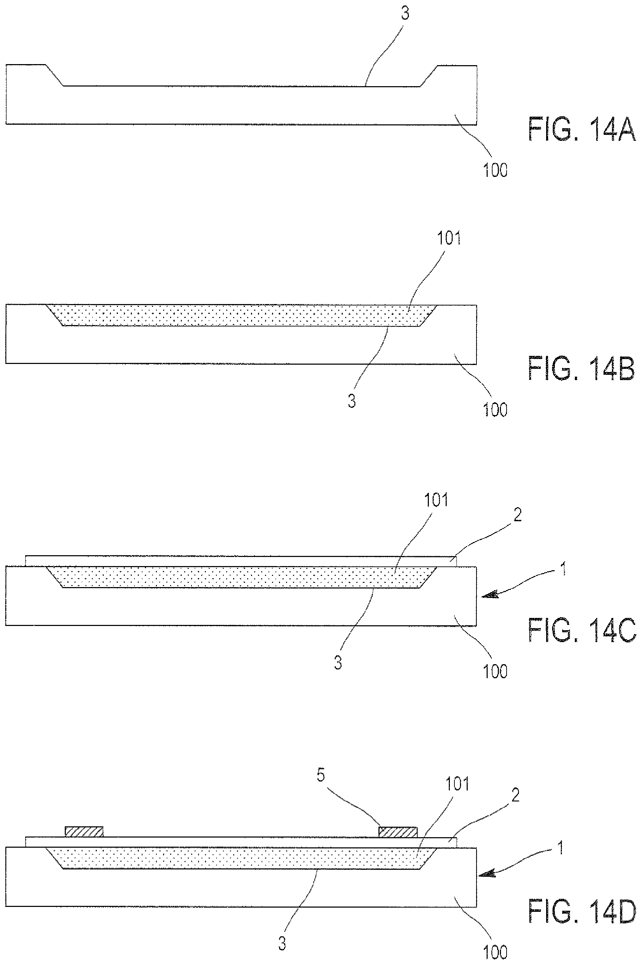

On va maintenant s'intéresser à un exemple de procédé de fabrication d'un dispositif optique à distance focale variable selon l'invention. On va utiliser une couche sacrificielle. On se reporte aux figures 14A à 14G.

On part d'un substrat 100 dans lequel une cuvette 3 a été gravée. Le substrat 100 peut être par exemple en verre (figure 14A). Il forme le support. On dépose dans la cuvette 3 un matériau sacrificiel 101 (figure 14B). Le matériau sacrificiel 101 peut être organique, une résine photosensible par exemple, ou un matériau minéral tel que de l'oxyde de silicium.

On forme la membrane 2 sur le matériau sacrificiel 101, de manière à ce qu'elle déborde sur le bord de la cuvette 3 et s'y ancre (figure 14C). On peut déposer un matériau choisi dans les matériaux énumérés plus haut pour la membrane 2. Le dépôt peut se faire à la tournette ou par dépôt chimique en phase vapeur.

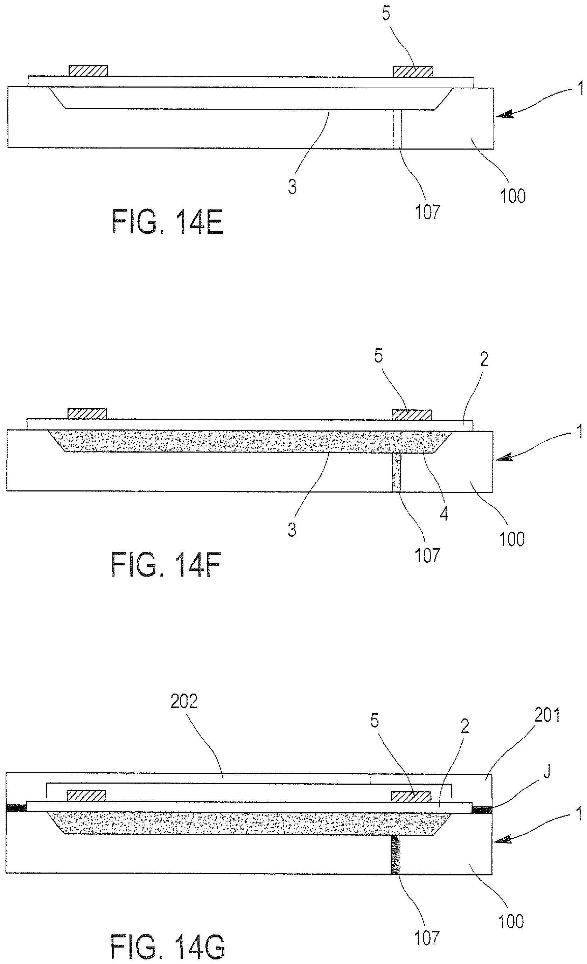

On forme ensuite les moyens d'actionnement 5 au niveau de la zone intermédiaire sans contact avec le support 1 (figure 14D). Ils sont déposés par des techniques utilisées dans les micro-systèmes telles que le dépôt en couche mince, la lithographie, la gravure. On libère ensuite la membrane 2 en éliminant le matériau sacrificiel. Pour cela, on peut percer au moins un trou 107, hors du champ optique (zone centrale), dans le substrat 100 jusqu'à atteindre le matériau sacrificiel 101. Le trou 107 est traversant et débouche dans la cuvette 3 (figure 14E). L'élimination peut être chimique ou thermique ou par plasma d'oxygène. On remplit ensuite la cuvette 3 avec le fluide 4 (figure 14F). Le remplissage peut se faire en mettant la cuvette 3 en dépression pour favoriser la pénétration du fluide 4 et éviter la formation de bulles s'il s'agit d'un liquide. Enfin on rebouche le trou 107 pour que le fluide 4 ne puisse pas s'échapper (figure 14F). On peut utiliser un matériau organique. L'ordre des étapes n'est pas limitatif.

Les moyens d'actionnement principaux 5 pourraient également être formés après la libération de la membrane 2 par exemple, avant le remplissage ou après. Il est également possible de les former sur la couche sacrificielle 101 avant de former la membrane 2, s'ils doivent se trouver en définitif du côté du fluide 4 emprisonné entre le support 1 et la membrane 2. Dans une telle configuration, la membrane 2 est sus-jacente aux moyens d'actionnement 5. Les moyens d'actionnement supplémentaires peuvent bien sûr être formés de la même manière que les moyens d'actionnement principaux. On ne les a pas représentés sur les figures 12 pour ne pas surcharger les figures.

Si l'on désire que la membrane 2 au repos soit bombée, concave ou convexe, on donne une courbure appropriée à la face libre de la couche sacrificielle 101, puisqu'elle sert de moule à la membrane 2. Une autre solution pour obtenir une membrane 2 bombée serait de la faire flamber après l'avoir libérée. Le flambage peut être thermique. Les paramètres déterminants sont alors la différence de coefficients de dilatation thermique entre la membrane 2 et le substrat et la température de dépôt de la membrane 2.

Pour protéger la membrane 2, il est possible que le dispositif optique de l'invention soit réalisé par l'assemblage d'un support 1 et d'un capot 201 comme on l'a décrit à la figure 9H. Il n'est pas obligatoire que le capot 201 soit plein, sur la figure 14G, il évidé dans sa partie centrale, l'ouverture porte la référence 202. Un joint J de colle est utilisé pour assembler le support 1 et le capot 201.

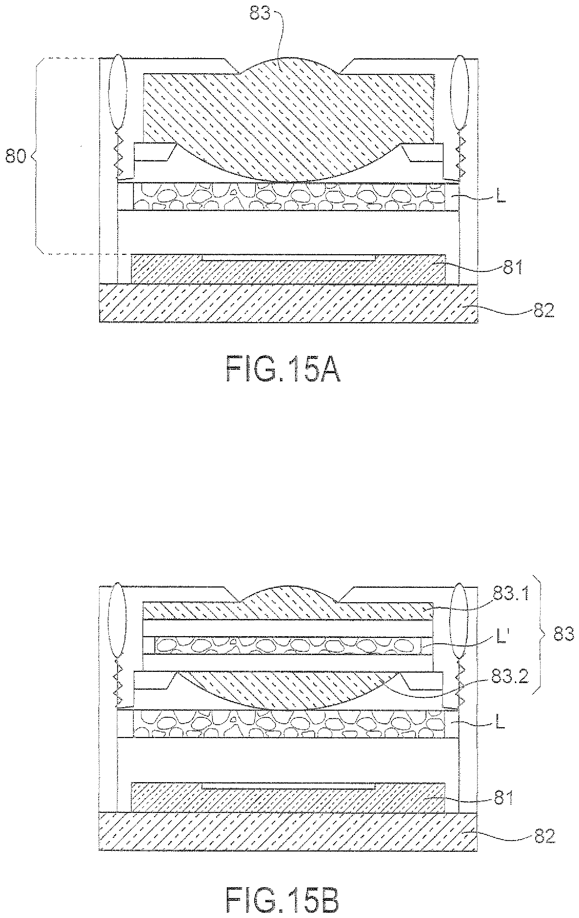

Un tel dispositif optique à distance focale variable peut être employé dans un dispositif de prise de vue notamment celui d'un appareil photo de téléphone portable. On se réfère à la figure 15A. Un tel dispositif de prise de vue comporte en cascade, un objectif 80 incluant au moins un dispositif optique à distance focale variable L selon l'invention de type lentille liquide, un capteur d'image 81 par exemple de type CCD ou CMOS porté par un substrat 82. Dans l'exemple décrit, l'objectif 80 comporte au moins une lentille 83 à distance focale fixe et une lentille liquide L selon l'invention. Par la suite cette lentille à distance focale fixe 83 sera appelée bloc optique conventionnel. La lentille liquide L se trouve entre le bloc optique conventionnel 83 et le capteur d'image 81. En variante le bloc optique conventionnel 83 peut se trouver entre la lentille liquide L et le capteur d'image 81. Le bloc optique conventionnel 83 est statique. Comme on l'a vu précédemment, de par son procédé de fabrication, la lentille liquide L peut être assimilée à un MOEMS (microsystème optoélectromécanique). La lentille liquide L à focale variable est placée à une certaine distance, qui dépend des caractéristiques de l'objectif 80, du capteur d'image 81, mais si cette distance est petite, la lentille liquide L et le capteur d'image 81 ne pourront faire qu'un seul composant en les intégrant soit en technologie AIC (abréviation anglo-saxonne de Above Integrated Circuit pour au-dessus du circuit inégré), soit en technologie WLCSP (abréviation anglo-saxonne de Wafer Level Chip Scale Package soit sur tranche à l'échelle de la puce). La distance focale de la lentille liquide L est adaptée en optimisant la pression du liquide au repos, mais aussi la courbure de la membrane 2 au repos et l'indice de réfraction du liquide.

Si le dispositif de prise de vue inclut également la fonction zoom comme sur la figure 15B, on utilisera, un bloc optique 83 avec au moins deux lentilles à distance focale fixe 83.1 83.2 et deux lentilles liquides L et L' dont l'une se trouve entre les deux lentilles 83.1, 83.2 du bloc optique 83 et l'autre à proximité du capteur d'image 81 comme sur la figure 15B. Sur ces figures 15A, 15B, les dispositifs optiques selon l'invention référencés L et L' sont représentés très schématiquement, on ne voit pas leurs moyens d'actionnement.

Avec un dispositif optique selon l'invention ayant un encombrement donné, on peut maximiser la surface des moyens d'actionnement en utilisant plusieurs actionneurs piézoélectriques agencés en plusieurs couronnes. L'énergie apportée par les moyens d'actionnement peut être maximisée ce qui permet soit d'améliorer les déplacements du fluide et donc d'améliorer les performances du dispositif optique à tension d'alimentation constante, soit de minimiser la tension d'alimentation à performances optiques équivalentes.

Les configurations à plusieurs couronnes d'actionneurs piézoélectriques dont au moins une comporte un seul actionneur piézoélectrique et au moins une comporte plusieurs actionneurs piézoélectriques élémentaires, permet d'obtenir une puissance d'actionnement élevée grâce à l'actionneur piézoélectrique unique de l'une des couronnes et une déformation non axisymétrique grâce aux actionneurs piézoélectriques élémentaires d'une autre couronne.

En ancrant les moyens d'actionnement principaux seulement à la membrane dans la zone intermédiaire, on peut réduire l'encombrement du dispositif par rapport aux configurations dans lesquelles les moyens d'actionnement sont ancrés sur le support.

Le fait de prévoir des moyens de compensation d'une variation de la distance focale due à une variation de température permet de maintenir constante la distance focale du dispositif quelle que soit la température prise dans une plage donnée.

Bien que plusieurs modes de réalisation de la présente invention aient été décrits de façon détaillée, on comprendra que différents changements et modifications puissent être apportés sans sortir du cadre de l'invention et notamment bien d'autres procédés peuvent être utilisés pour réaliser la membrane et les moyens d'actionnement.

## Revendications

1. Dispositif optique à membrane (2) déformable ayant un champ optique comportant une zone d'ancrage (2.3) sur un support (1) contribuant à emprisonner une quantité de fluide liquide ou gazeux sensiblement constante, une zone centrale (2.1) correspondant au champ optique apte à se déformer de manière réversible depuis une position de repos, des moyens d'actionnement pour déplacer le fluide (4) sollicitant la membrane (2) dans une zone intermédiaire entre la zone d'ancrage (2.3) et la zone centrale (2.1), **caractérisé en ce que** les moyens d'actionnement comportent des moyens d'actionnement principaux (5) piézoélectriques, agencés en au moins une couronne (C) montée autour de la zone centrale (2.1) et hors de celle-ci, chaque couronne (C) comportant un ou plusieurs actionneurs piézoélectriques (5.1), et des moyens d'actionnement supplémentaires (5') piézoélectriques, agencés en au moins une couronne (C) montée autour de la zone centrale (2.1) et qui entourent les moyens d'actionnement principaux (5), chaque couronne (C) comportant un ou plusieurs actionneurs piézoélectriques (5.1'), ces moyens d'actionnement principaux piézoélectriques étant ancrés uniquement sur la zone intermédiaire (2.2) de la membrane (2), ces moyens d'actionnement supplémentaires piézoélectriques étant ancrés sur la zone intermédiaire (2.2) et éventuellement sur le support (1), la zone centrale (2.1) étant exempte de moyens d'actionnement, ces moyens d'actionnement principaux piézoélectriques, ces moyens d'actionnement supplémentaires piézoélectriques (5') et la membrane à laquelle ils sont ancrés formant au moins un bimorphe piézoélectrique, les moyens d'actionnement principaux piézoélectriques et les moyens d'actionnement supplémentaires piézoélectriques se contractant ou s'étendant radialement lors d'un actionnement de manière à engendrer un déplacement dudit fluide (4) depuis la zone intermédiaire (2.2) vers la zone centrale (2.1) de la membrane (2) ou vice versa visant à déformer la zone centrale (2.1) par rapport à sa position de repos, et à permettre à la membrane d'avoir une déformée à un ou deux points d'inflexion radialement.

2. Dispositif optique selon la revendication 1, les moyens d'actionnement principaux piézoélectriques et les moyens d'actionnement supplémentaires piézoélectriques sont actionnables de manière indépendante, de manière simultanée ou successivement.

3. Dispositif optique selon la revendication 1 dans lequel, lorsque l'on compte plusieurs couronnes pour les moyens d'actionnement piézoélectriques principaux et/ou supplémentaires (5, 5') elles sont montées concentriquement entre elles.

4. Dispositif optique selon l'une des revendications 1 à 3, dans lequel un actionneur piézoélectrique (5.1, 5.1')) des moyens d'actionnement piézoélectriques principaux et/ou supplémentaires (5, 5') prend la forme d'une couronne continue.

5. Dispositif optique selon l'une des revendications 1 à 3, dans lequel les actionneurs piézoélectriques (5.1, 5.1') d'une même couronne prennent la forme de secteurs de couronne (SC) ou de barreaux (B) orientés radialement espacés entre eux, la couronne étant morcelée ou continue.

6. Dispositif optique selon la revendication 5, dans lequel plusieurs actionneurs piézoélectriques (5.1, 5.1') d'une même couronne ou de couronnes voisines partagent un même bloc (50) de matériau piézoélectrique.

7. Dispositif optique selon l'une des revendications précédentes, dans lequel les moyens d'actionnement (5, 5') sont ancrés sur une face de la membrane (2) en contact avec ledit fluide (4) et/ou sur une face de la membrane sans contact avec ledit fluide (4) et/ou sont intégrés dans la membrane (2).

8. Dispositif optique selon l'une des revendications précédentes, dans lequel la membrane (2) comporte au moins localement une couche de renfort (2c) au niveau de la zone intermédiaire (2.2) de manière à ce que la zone intermédiaire (2.2) au niveau de cette couche de renfort (2c) soit plus rigide que la zone centrale (2.1).

9. Dispositif optique selon l'une des revendications précédentes, dans lequel la membrane (2) comporte au niveau de la zone centrale (2.1) une couche continue (2b) qui occupe la zone intermédiaire (2.2) et la zone d'ancrage (2.3).

10. Dispositif optique selon l'une des revendications précédentes, comportant des moyens de compensation (95) d'une variation de la distance focale du dispositif optique en fonction de la température.

11. Dispositif optique selon la revendication 10, dans lequel les moyens de compensation (95) sont confondus avec le ou les actionneurs piézoélectriques d'une couronne.

12. Dispositif optique selon la revendication 10, dans lequel les moyens de compensation (95) comportent un ou plusieurs éléments bimorphes (95.1) thermiques agencés en couronne soit ancrés sur la membrane (2) au niveau de la zone d'ancrage (2.3) en débordant sur la zone intermédiaire (2.2), soit fixés au support (1) à l'opposé de la membrane (2) par rapport audit fluide (4).

13. Dispositif optique selon l'une des revendications précédentes, dans lequel les moyens d'actionnement comportent un ou plusieurs actionneurs piézoélectriques agencés en couronne ayant une périphérie intérieure et une périphérie extérieure, la couronne se prolongeant sur une de ses périphéries par des actionneurs piézoélectriques (5.1) en barreaux orientés radialement.

14. Dispositif optique selon l'une des revendications précédentes, comportant un ou plusieurs actionneurs piézoélectriques agencés en une couronne, ancrés sur la membrane dans la zone intermédiaire et éventuellement dans la zone d'ancrage, aptes à fonctionner passivement par effet piézoélectrique direct et dédiés à une surveillance d'une déformation de la membrane.

15. Dispositif optique selon l'une des revendications précédentes, comportant en outre un capot (201) de protection fixé sur le support (1), le capot (201) étant muni d'une ouverture (202) au niveau de la zone centrale (2.1) ou étant étanche et emprisonnant un autre fluide (4').

16. Dispositif optique selon l'une des revendications précédentes, **caractérisé en ce que** c'est une lentille ou un miroir.

17. Dispositif de prise de vue, **caractérisé en ce qu'**il comporte au moins un dispositif optique (L, L') selon l'une des revendications précédentes.

## Patentansprüche

1. Optische Vorrichtung mit einer verformbaren Membran (2), die ein Sichtfeld aufweist, das einen Verankerungsbereich (2.3) auf einem Träger (1) der dazu beiträgt eine im wesentlichen konstante Menge eines flüssigen oder gasförmigen Fluids einzuschließen, einen zentralen Bereich (2.1), der dem Sichtfeld entspricht und eingerichtet ist, um sich auf reversible Weise von einer Ruheposition zu verformen, Betätigungsmittel, um das Fluid (4) zu verschieben, wodurch die Membran (2) in einen Zwischenbereich zwischen dem Verankerungsbereich (2.3) und dem zentralen Bereich (2.1) angezogen wird, **dadurch gekennzeichnet, dass** die Betätigungsmittel hierzu piezoelektrische Hauptbetätigungsmittel (5) umfassen, die auf zumindest einem Kranz (c) angeordnet sind, der um den zentralen Bereich (2.1) herum und außerhalb davon montiert ist, wobei jeder Kranz (C) einen oder mehrere piezoelektrische Aktuatoren (5.1) und zusätzliche piezoelektrische Betätigungsmittel (5') umfasst, die auf zumindest einem Kranz(C) angeordnet sind, der um den zentralen Bereich (2.1) montiert ist, und die die Hauptbetätigungsmittel (5) umgeben, wobei jeder Kranz (C) einen oder mehrere piezoelektrische Aktuatoren (5.1') umfasst, wobei die piezoelektrischen Hauptbetätigungsmittel nur in dem Zwischenbereich (2.2) der Membran (2) verankert sind, wobei die piezoelektrischen zusätzlichen Betätigungsmittel auf dem Zwischenbereich (2.2) verankert sind und möglicherweise auf dem Träger (1), wobei der zentrale Bereich (2.1) keine Betätigungsmittel aufweist, wobei die piezoelektrischen Hauptbetätigungsmittel, die zusätzlichen piezoelektrischen Betätigungsmittel (5') und die Membran an der sie verankert sind mindestens einen piezoelektrischen Bimorph bilden, wobei die piezoelektrischen Hauptbetätigungsmittel und die zusätzlichen piezoelektrischen Betätigungsmittel sich in radialer Richtung zusammenzuziehen oder auszudehnen bei einer Betätigung auf eine Weise, die eine Verschiebung des Fluids (4) aus dem Zwischenbereich (2.2) in den zentralen Bereich (2.1) der Membran (2) oder umgekehrt verursacht mit dem Ziel den zentralen Bereich (2.1) bezüglich seiner Ruheposition zu verformen und mit dem Ziel es der Membran zu ermöglichen, sich mit einem oder zwei radialen Wendepunkten zu verformen.

2. Optische Vorrichtung nach Anspruch 1, wobei die piezoelektrischen Hauptbetätigungsmittel und die zusätzlichen piezoelektrischen Betätigungsmittel gleichzeitig oder aufeinanderfolgend unabhängig betätigbar sind.

3. Optische Vorrichtung nach Anspruch 1, wobei, wenn eine Vielzahl von Kränzen für die piezoelektrischen Haupt-und/oder zusätzlichen Betätigungsmittel (5, 5') vorliegt, diese zueinander konzentrisch montiert sind.

4. Optische Vorrichtung nach einem der Ansprüche 1 bis 3, wobei ein piezoelektrischer Aktuator (5.1, 5.1') der piezoelektrischen Haupt-und/oder zusätzlichen Betätigungsmittel (5, 5') die Form eines kontinuierlichen Kranzes aufweist.

5. Optische Vorrichtung nach einem der Ansprüche 1 bis 3, wobei die piezoelektrischen Aktuatoren (5.1, 5.1') eines selben Kranzes die Form von Abschnitten des Kranzes (SC) oder von Stäben (B) annehmen, die radial voneinander getrennt ausgerichtet sind wobei der Kranz aufgeteilt oder kontinuierlich ist.

6. Optische Vorrichtung nach Anspruch 5, wobei mehrere der piezoelektrischen Aktuatoren (5.1, 5.1') eines selben Kranzes oder benachbarter Kränze einen selben Block (50) piezoelektrischen Materials teilen.

7. Optische Vorrichtung nach einem der vorangegangenen Ansprüche, wobei die Betätigungsmittel (5, 5') auf einer Oberfläche der Membran (2), die sich in Kontakt mit dem Fluid (4) befindet, und/oder auf einer Oberfläche der Membran verankert sind, die sich nicht in Kontakt mit dem Fluid (4) befindet und/oder in die Membran (2) integriert sind.

8. Optische Vorrichtung nach einem der vorangegangenen Ansprüche, wobei die Membran (2) zumindest lokal eine Verstärkungsschicht (2c) im Bereich des Zwischenbereichs (2.2) umfasst, sodass der Zwischenbereich (2.2) im Bereich der Verstärkungsschicht (2c) steifer ist als in dem zentralen Bereich (2.1).

9. Optische Vorrichtung nach einem der vorangegangenen Ansprüche, wobei die Membran (2) im Bereich des zentralen Bereichs (2.1) eine kontinuierliche Schicht (2b) umfasst, die den Zwischenbereich (2.2) und den Verankerungsbereich (2.3) einnimmt.

10. Optische Vorrichtung nach einem der vorangegangenen Ansprüche umfassend Mittel (95) zum Kompensieren einer Veränderung der Brennweite der optischen Vorrichtung in Abhängigkeit der Temperatur.

11. Optische Vorrichtung nach Anspruch 10, wobei die Mittel (95) zum Kompensieren mit dem oder den piezoelektrischen Aktuatoren eines Kranzes kombiniert sind.

12. Optische Vorrichtung nach Anspruch 10, wobei die Mittel (95) zum Kompensieren ein oder mehrere bimorphe thermische Elemente (95.1) umfassen, die auf einem Kranz angeordnet sind, der entweder auf der Membran (2) im Bereich des Verankerungsbereichs (2.3) verankert ist, indem er an den Zwischenbereich (2.2) angrenzt, oder auf dem Träger (1) gegenüber der Membran (2) hinsichtlich des Fluids (4) angeordnet ist.

13. Optische Vorrichtung nach einem der vorangegangenen Ansprüche, wobei die Betätigungsmittel einen oder mehrere piezoelektrische Aktuatoren beinhalten, die im Kranz angeordnet sind, der einen inneren Umfang und einen äußeren Umfang aufweist, wobei sich der Kranz auf einem seiner Umfänge um piezoelektrische Betätigungsmittel (5.1) in Stabform, die radial angeordnet sind, erstreckt.

14. Optische Vorrichtung nach einem der vorangegangenen Ansprüche, umfassend einen oder mehrere piezoelektrische Aktuatoren, die in einem Kranz angeordnet sind, der auf der Membran in dem Zwischenbereich und möglicherweise in dem Verankerungsbereich verankert ist, die eingerichtet sind, um passiv über einen direkten piezoelektrischen Effekt zu funktionieren und die für eine Überwachung einer Verformung der Membran bestimmt sind.

15. Optische Vorrichtung nach einem der vorangegangenen Ansprüche, weiter umfassend eine Schutzabdeckung (201), die auf dem Träger (1) befestigt ist, wobei die Abdeckung (201) eine Öffnung (202) im Bereich des zentralen Bereichs (2.1) aufweist oder wasserdicht ist und ein anderes Fluid (4') einschließt.

16. Optische Vorrichtung nach einem der vorangegangenen Ansprüche, **dadurch gekennzeichnet, dass** sie eine Linse oder ein Spiegel ist.

17. Sichtfeldvorrichtung, **dadurch gekennzeichnet, dass** sie zumindest eine optische Vorrichtung (L, L') gemäß einem der vorangegangenen Ansprüche umfasst.

## Claims

1. Optical device with a deformable membrane (2) having a field of view comprising an anchoring area (2.3) on a substrate (1) contributing to trapping a substantially constant quantity of liquid or gaseous fluid, a central area (2.1) corresponding to the field of view capable of reversibly deforming from a rest position, actuation means for moving the fluid (4), stressing the membrane (2) in an intermediate area between the anchoring area (2.3) and the central area (2.1), **characterised in that** the actuation means comprise main piezoelectric actuation means (5), arranged into at least one ring (C) mounted around the central area (2.1) and outside of said area, each ring (C) comprising one or more piezoelectric actuators (5.1), and additional piezoelectric actuation means (5'), arranged into at least one ring (C) mounted around the central area (2.1) and surrounding the main actuation means (5), each ring (C) comprising one or more piezoelectric actuators (5.1'), said main piezoelectric actuation means being anchored onto the intermediate area (2.2) of the membrane (2) only, said additional piezoelectric actuation means being anchored onto the intermediate area (2.2) and potentially onto the substrate (1), the central area (2.1) being free from actuation means, said main piezoelectric actuation means, said additional piezoelectric actuation means (5') and the membrane to which the means are anchored forming at least one piezoelectric bimorph, the main piezoelectric actuation means and the additional piezoelectric actuation means radially contracting or radially expanding upon an actuation so as to cause said fluid (4) to move from the intermediate area (2.2) to the central area (2.1) of the membrane (2) or vice-versa with the intention of deforming the central area (2.1) with regard to its rest position, and of enabling the membrane to have a distorted shape with one or two points of inflexion radially.

2. Optical device according to claim 1, wherein the main piezoelectric actuation means and the additional piezoelectric actuation means can be actuated independently, simultaneously or successively.

3. Optical device according to claim 1 wherein, if a plurality of rings is present for the main and/or additional piezoelectric actuation means (5, 5'), they are mounted in a concentric manner with regard to each other.

4. Optical device according to one of claims 1 to 3, wherein a piezoelectric actuator (5.1, 5.1') of the main and/or additional piezoelectric actuation means (5, 5') takes on the shape of a continuous ring.

5. Optical device according to one of claims 1 to 3, wherein the piezoelectric actuators (5.1, 5.1') of the same ring take on the shape of ring sectors (SC) or bars (B) oriented radially and spaced apart, the ring being fragmented or continuous.

6. Optical device according to claim 5, wherein a plurality of piezoelectric actuators (5.1, 5.1') of the same ring or of neighbouring rings share the same block (50) of piezoelectric material.

7. Optical device according to one of the previous claims, wherein the actuation means (5, 5') are anchored onto one surface of the membrane (2) in contact with said fluid (4) and/or onto one surface of the membrane not in contact with said fluid (4) and/or are incorporated into the membrane (2).

8. Optical device according to one of the previous claims, wherein the membrane (2) comprises at least locally a strengthening layer (2c) at the level of the intermediate area (2.2) such that the intermediate area (2.2) at the level of this strengthening layer (2c) is stiffer than the central area (2.1).

9. Optical device according to one of the previous claims, wherein the membrane (2) comprises at the level of the central area (2.1) a continuous layer (2b) that occupies the intermediate area (2.2) and the anchoring area (2.3).

10. Optical device according to one of the previous claims, comprising compensation means (95) compensating for a variation in the focal distance of the optical device according to the temperature.

11. Optical device according to claim 10, wherein the compensation means (95) are combined with the piezoelectric actuator(s) of a ring.

12. Optical device according to claim 10, wherein the compensation means (95) comprise one or more thermal bimorph elements (95.1) arranged in a ring, either anchored onto the membrane (2) at the level of the anchoring area (2.3) and protruding onto the intermediate area (2.2), or secured to the substrate (1) opposite the membrane (2) in relation to said fluid (4).

13. Optical device according to one of the previous claims, wherein the actuation means comprise one or more piezoelectric actuators arranged in a ring, having an inner periphery and an outer periphery, the ring extending along one of its peripheries by piezoelectric actuators (5.1) in the form of bars oriented radially.

14. Optical device according to one of the previous claims, comprising one or more piezoelectric actuators arranged in a ring, anchored onto the membrane in the intermediate area and potentially in the anchoring area, capable of operating passively by direct piezoelectric effect and dedicated to monitoring a deformation of the membrane.

15. Optical device according to one of the previous claims, further comprising a protective cover (201) secured to the substrate (1), the cover (201) being provided with an aperture (202) at the level of the central area (2.1) or being sealed and enclosing another fluid (4').

16. Optical device according to one of the previous claims, **characterised in that** it is a lens or a mirror.

17. Image capture device, **characterised in that** it comprises at least one optical device (L, L') according to one of the previous claims.
